(19) Europäisches Patentamt
European Patent Office
Office européen des brevets

(11) EP 1 829 945 A1

(12) **EUROPEAN PATENT APPLICATION**
published in accordance with Art. 158(3) EPC

(43) Date of publication:
**05.09.2007 Bulletin 2007/36**

(21) Application number: **05819850.8**

(22) Date of filing: **21.12.2005**

(51) Int Cl.:
***C09D 201/10*** *(2006.01)* ***C01B 33/12*** *(2006.01)*
***C09D 1/00*** *(2006.01)* ***C09D 183/02*** *(2006.01)*
***C09D 183/04*** *(2006.01)* ***H01L 21/316*** *(2006.01)*

(86) International application number:
**PCT/JP2005/023499**

(87) International publication number:
**WO 2006/068181 (29.06.2006 Gazette 2006/26)**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **21.12.2004 JP 2004369221**
**07.01.2005 JP 2005002382**
**12.04.2005 JP 2005114558**
**09.08.2005 JP 2005231202**

(71) Applicant: **Hitachi Chemical Co., Ltd.**
**Shinjuku-ku,**
**Tokyo 163-0449 (JP)**

(72) Inventors:
- **SAKURAI, Haruaki,**
  **c/o Yamazaki Works**
  **Hitachi-shi, Ibaraki 3178555 (JP)**
- **YOSHIKAWA, Takahiro,**
  **c/o Yamazaki Works**
  **Hitachi-shi, Ibaraki 3178555 (JP)**

(74) Representative: **Jönsson, Hans-Peter**
**Von Kreisler Selting Werner,**
**Deichmannhaus am Dom,**
**Bahnhofsvorplatz 1**
**50667 Cologne (DE)**

(54) **FILM, SILICA FILM AND METHOD OF FORMING THE SAME, COMPOSITION FOR FORMING SILICA FILM, AND ELECTRONIC PART**

(57) The coating film of the invention is obtained by curing an applied film formed by application of a composition containing an organic solvent with a boiling point of 80°C or higher, wherein the shrinkage ratio of the film thickness from the applied film immediately after application is no greater than 27%.

EP 1 829 945 A1

## Description

## Technical Field

The present invention relates to a coating film and a silica-based coating film and a method for forming thereof, a composition for forming a silica-based coating film and an electronic part.

## Background Art

Aluminum (Al) has conventionally been used as a wiring metal for electronic device parts including semiconductor elements such as LSIs, and flat panel displays (FPD). Also, $SiO_2$ films formed by CVD and having relative permittivity of about 4.2 have been used as interlayer insulating films. However, from the viewpoint of reducing the resistance value of the wiring metal and improving LSI operating speed, it has been desirable to shift to lower resistance copper (Cu) wiring in logic devices, and Cu wiring has begun to be applied from a design rule of 130 nm. In addition, from the viewpoint of reducing the interconnect capacitance of devices and improving LSI operating speed, it has been desirable to use materials that can exhibit even lower permittivity.

On the other hand, research and development has also begun toward reducing the permittivity of the interlayer insulating film when using conventional aluminum (Al) as the wiring metal in memory devices such as DRAMs, or flat panel displays (FPD).

In response to the demand for lower permittivity, SiOF films formed by CVD have been developed that have a relative permittivity of about 3.5. There have also been developed organic SOG (Spin On Glass) and organic polymers as insulating materials with relative permittivities of 2.5-3.0. Porous materials that provide voids in the coating film have been considered effective as insulating materials with a relative permittivity of 2.5 or lower, while research and development is also being actively pursued for the use of such porous materials in LSI interlayer insulating films.

As methods of forming such porous materials there have been proposed methods using organic SOG, as described in Patent documents 1 and 2. In such methods, a composition comprising a metal alkoxide hydrolyzable condensation polymer and a volatile or decomposable polymer is heated and formed into a coating film, after which the coating film is heated to form pores in the coating film to obtain a porous material.

When the wiring material is Al, however, the insulating film is formed in the grooves (as trench; hereinafter also referred to as "recesses" as necessary) between wirings after formation of the Al wiring, and therefore an insulating material has been desired that not only has a low permittivity property but can also form an insulating film that fills the recesses between wirings without voids and has a flat surface.

Surface flattening techniques have been proposed in the past, using siloxane polymers with reflow properties as described in Patent documents 3 and 4, for example. Methods using organic polymers such as polyimides are also known.

Bias sputtering processes are also known, wherein a coating film is formed while lightly bombarding the substrate with charged particles to prevent residual gases such as hydrogen, oxygen and nitrogen from remaining in the substrate. This process is suitable for flattening of surfaces at microsections, but its drawback is that it produces damage in the underlying substrate during the course of film accumulation.

[Patent document 1] Japanese Patent Application Laid-Open No. 11-322992
[Patent document 2] Japanese Patent Application Laid-Open No. 11-310411
[Patent document 3] Japanese Patent No. 3370792
[Patent document 4] Japanese Patent Application Laid-Open No. 01-216543

## Disclosure of the Invention

### Problems to be Solved by the Invention

Incidentally, increasing signal delay time due to greater interconnect capacitance has become a problem with electronic device parts including semiconductor elements such as LSIs, and flat panel displays (FPD), as micronization of wiring advances as a result of higher integration. It has therefore been a goal to improve the heat resistance and mechanical properties of insulating materials for electronic device parts, as well as to achieve even lower relative permittivity and lower temperatures and shorter times for heat treatment steps.

Generally speaking, a relationship exists between the signal propagation velocity (v) of wiring and the relative permittivity (ε) of an insulating material in contact with the wiring material, which is represented by the formula: $v = k/\sqrt{\varepsilon}$. That is, the signal propagation is increased by augmenting the frequency range used and lowering the relative permittivity (ε) of the insulating material.

Also, a high-temperature atmosphere of at least 450°C is necessary for curing of conventional insulating material coating film-forming compositions to form coating films. A long period of about 1 hour is usually necessary as well, to complete the final curing. When using such coating films as interlayer insulating films, therefore, deterioration of other layers due to the thermal budget is a concern during the coating film-forming process. For example, deterioration of transistors and underlying wiring layers is a concern in the case of semiconductor elements such as LSIs. In the case of flat panel displays (FPD), deterioration of transistors is a concern. Moreover, increase in thermal budgets has led to the problem of significant warping of substrates in electronic device parts. The warping of substrates is a particularly notable issue with flat panel displays (FPD) that using large-size glass panels.

As mentioned above, ever accelerating micronization of wirings due to higher integration is necessitating reduced thicknesses and increased numbers of the various member layers composing semiconductor devices, and leading to changes in the materials of wiring layers and the like. As the effects of deterioration of member layer materials due to the thermal budget are therefore expected to increase beyond what is currently experienced, it is urgent to improve the thermal history by reducing the heat load in each process.

For devices employing Al wiring, it is essential to fill the interconnect recesses without voids, to ensure flatness of the coating film surface, to prevent unevenness of application such as striation in the plane of the substrate surface (radial stripes running from the center toward the periphery of the substrate), and to ensure plasma resistance during formation of upper layer Al wirings. High transparency is also required for flat panel displays (FPD).

The present inventors have conducted detailed research on conventional coating film-forming processes wherein coating films are formed on wiring-formed substrates. Fig. 3 is an end view flow chart showing the process starting immediately after application of a coating film material until curing of the coating film, using a conventional dehydrating condensation-type siloxane polymer with no reflow property. Here, in the post-application step (a) after the coating film material has been applied onto the substrate 100 on which a wiring 150 has been formed, the flatness of the surface of the coated film (as coat film; hereinafter also referred to as "applied film" as necessary) 110 is relatively good. However, as the siloxane polymer proceeds from post-application (a) through the drying step (b) to the curing step (c), volatilization and dehydrating condensation of the solvent occur, thereby increasing the shrinkage ratio of the film thickness from the post-application coated film 110 to the cured coating film 120 (hereinafter referred to as "film shrinkage ratio"). It was also found that, since the polymer has no reflow property, the surface flatness above the recesses 130 is poor and the coating film fails to sufficiently fill in the recesses 130, thus producing voids caused by indentations 170. Particularly in the case of flat panel displays (FPD), the Al wiring width is at least 1 $\mu$m but since the difference in film thickness within the plane is associated with color irregularities, a stricter degree of flatness is sought than with semiconductors.

It was further found that, in the case of dehydrating condensation-type siloxane polymers with no reflow property, the film shrinkage ratio is high and therefore voids are produced in the recesses. This tends to be notable with smaller volumes of recesses (spaces). Specifically, the contact holes and via holes are more prominent than the interconnect grooves. Production of such voids is believed to occur because the film merely experiences film shrinkage without reflow during the period from post-application to the curing step.

Fig. 4 is an end view flow chart similar to Fig. 3, where the coating film material is a conventional dehydrating condensation-type siloxane polymer with no reflow property. Since the coating film material has a reflow property, even if indentations are produced on the coated film 210 surface on the recesses 230 during the period from post-application (a) to the drying step (b), the coating film material composing the coated film 210 flows into the indentations 270. Consequently, the recesses 230 are filled without voids and a coating film surface with excellent flatness is satisfactorily formed. However, the siloxane polymer with a reflow property disclosed in Patent document 3 has an even larger film shrinkage ratio from the coated film 210 at post-application (a) to the coating film 220 after the curing step (c). This is attributed to alkoxy groups which are intentionally left in the polymer solution. When the film shrinkage ratio is high during curing of the film, it was found that volume changes become more influential with pattern substrate recesses, such that micronized Al wirings with design rules of 130 nm or smaller may drop or deform, or the interlayer insulating film may peel from the Al wiring. It was additionally found that since alkoxy groups are intentionally left in the solution, siloxane polymers with a reflow property are poorly suited for reducing the curing temperature and shortening the curing time.

Particularly with flat panel displays (FPD), process restrictions make it desirable to have a curing temperature of no higher than 350°C, and therefore the aforementioned siloxane polymer with a reflow property cannot be considered useful.

The siloxane polymer with a reflow property described in Patent document 4 is either an addition reaction-type siloxane resin (Example 1) or a ladder siloxane with poor adhesion and crack resistance (Example 2), and therefore the issues of heat resistance and adhesion remain. With addition reaction-type siloxanes, it is assumed that the film shrinkage ratio from the post-application coated film to the cured coating film is minimal, but heat resistance is a problem as indicated above, and they are therefore not suitable for processing.

The siloxane polymers with a reflow property as described in Patent documents 3 and 4 have a relative permittivity of about 3, which is a low dielectric characteristic. However, such siloxane polymers tend to have a greater total proportion of C atoms per mole of Si atoms, and tend to have inferior mechanical strength. Also, when voids are introduced

to lower the relative permittivity, the mechanical strength tends to be even poorer.

Similarly, coating films obtained from organic polymers such as polyimides readily undergo thermal decomposition at temperatures of about 300-450°C, and therefore their heat resistance and humidity resistance are inferior. Their transparency also tends to be inferior in the wavelength range of 300-800 nm. In addition they tend to have low resistance against the plasma used for working of upper layer Al wirings.

Thus, several problems are still faced within the prior art, and specifically, no insulating material exists that is entirely suitable in terms of reasonably low permittivity, satisfactory coatability and heat resistance, high mechanical strength, satisfactory surface flatness and a low film shrinkage ratio.

The present invention has been accomplished in light of these circumstances, and its object is to provide a coating film and a silica-based coating film that exhibit especially superior surface flatness, a composition for a silica-based coating film, and a process for forming the film, as well as electronic parts comprising the silica-based coating film.

## Means for Solving the Problems

Although siloxane polymers with a reflow property have been widely used in the prior art to improve film flatness, the films obtained from such siloxane polymers have had high film shrinkage ratios during curing processes. Molecular design aimed at controlling the film shrinkage ratio, however, merely produces inferior surface flatness without allowing reflow.

The present inventors therefore conducted a great deal of detailed research on methods of the prior art, focusing on the fact that dehydrating condensation-type siloxane polymers with no reflow property have reasonably satisfactory post-application film surface flatness. If volume change of the film from post-application to post-curing, i.e. the film shrinkage ratio, can be minimized with a dehydrating condensation-type siloxane polymer having no reflow property, then the post-application film surface flatness can be maintained so that satisfactory degree of surface flatness can be achieved, making it possible to prevent dropping or deformation of micronized Al wirings due to film shrinkage during the curing process, and to prevent peeling of the interlayer insulating film from the Al wiring. The theoretical explanation is that keeping the film shrinkage ratio within a prescribed range can reduce volume changes in the film, thus minimizing the possibility of dropping of the Al wiring. However, the prior art does not provide a material that can minimize the film shrinkage ratio, or even the concept of minimizing the film shrinkage ratio to improve surface flatness.

As a result of much diligent research aimed at achieving the object stated above, and consideration of material components and compositions that can yield silica-based coating films suitable as insulating films, the present inventors have discovered that a composition comprising specific components can solve the various problems of the prior art, and the invention has been completed upon this discovery.

Specifically, the invention provides [1] a coating film obtained by curing an applied film formed by application of a composition containing an organic solvent with a boiling point of 80°C or higher, wherein the shrinkage ratio of the film thickness from the post-application applied film is no greater than 27%. The coating film has a film thickness of at least 73% with respect to the film thickness of the applied film.

The coating film of the invention, formed from a composition comprising an organic solvent with a boiling point of 80°C or higher, and exhibiting a film thickness shrinkage ratio from the post-application applied film of no greater than 27%, can fill in the recesses present between Al wirings and the like without leaving voids and has sufficiently excellent surface flatness, thus reducing the load on the Al wiring and substrate.

Two possible methods may be employed to minimize the film thickness shrinkage ratio during curing (hereinafter referred to as "film shrinkage ratio"). The first is a method of sufficiently promoting condensation reaction after application and inhibiting shrinkage of the coating film during the subsequent curing process, while the second is a method of carrying out condensation reaction while forming voids in the applied film during the curing process after application to alleviate shrinkage. However, even when a coating film is successfully formed by the second method, the film density is expected to be low and the mechanical strength poor. We therefore attempted to minimize the film shrinkage ratio by the first method.

It is currently understood that siloxane polymers with a reflow property have high film shrinkage ratios because alkoxy groups are intentionally left in the solution. Additional causes for the high film shrinkage ratio are believed to be volatilization and dehydrating condensation of the solvent, that occur as the curing process proceeds after application. In order to minimize the film shrinkage ratio, therefore, it was thought preferable to leave no alkoxy groups, to avoid leaving solvent in the applied film immediately after application and to allow the dehydrating condensation reaction to proceed to some extent while in the post-application state, and as a result, a coating film-forming composition was completed that can achieve a film shrinkage ratio of 27% or lower.

The invention also relates to [2] the aforementioned coating film which is formed from a composition containing a resin produced by condensation reaction induced by heat or radiation.

The invention further relates to [3] a coating film according to [1] or [2] above, which is formed from a composition for forming a silica-based coating film.

The coating film is preferably a silica-based coating film formed from a composition for forming a silica-based coating film because the system in which the condensation reaction is carried out will tend to have improved adhesiveness. The improved adhesiveness is attributed to chemical bonding with the underlying layer during application. The silica-based coating film has more excellent heat resistance and humidity resistance compared to a coating film composed of an organic polymer.

The invention further relates to [4] a coating film obtained by curing an applied film formed on the surface of a substrate having raised and indented sections on the surface, wherein the coating film has a film thickness shrinkage ratio of no greater than 27% from the applied film immediately after formation.

The invention still further relates to [5] a composition for forming a silica-based coating film which forms a coating film according to [3] above, the composition for forming a silica-based coating film comprising component (a): a siloxane resin, component (b): an organic solvent containing at least one aprotic solvent, and component (c): a condensation accelerator catalyst.

The composition for forming a silica-based coating film of the invention comprises a siloxane resin as a coating film-forming component, includes as an essential component an aprotic solvent as the organic solvent component for dissolution of the siloxane resin, and further contains a condensation accelerator catalyst. The coating film formed from the composition for forming a silica-based coating film is particularly resistant to film irregularities such as striation, has excellent in-plane uniformity of film thickness, fills in recesses without voids and has excellent surface flatness. The excellent surface flatness is attributed to a low film shrinkage ratio when the applied film composed of the composition for forming a silica-based coating film is cured. According to the invention it is also possible to form a silica-based coating film which has excellent surface flatness, very low dielectricity and especially low dielectricity in the high frequency range (the high frequency range of 100 kHz and higher, such as 1 MHz) and sufficient mechanical strength, and which can be cured at low temperature and in a short period of time compared to the prior art. Furthermore, since the composition can be cured at low temperature and in a short period of time, the thermal budget during the coating film-forming process is also alleviated. Consequently, problems such as deterioration of the wiring layer or warping of the substrate can be avoided.

While the reason for the effect described above is not fully understood, it is conjectured that the silica-based coating film exhibits low dielectricity and sufficient mechanical strength mainly due to the use of the siloxane resin and the aprotic solvent, and that the low film shrinkage ratio and excellent surface flatness with filling of the recesses without voids, and the ability to be cured at low temperature and in a short period of time are due primarily to the use of the aprotic solvent and the condensation accelerator catalyst. It is believed that the silica-based coating film is resistant to film irregularities such as striation and has excellent in-plane uniformity of film thickness primarily due to the use of the siloxane resin and aprotic solvent, and that the tendency is stronger if the solvent has a boiling point of 80-180°C.

The invention further relates to [6] a composition for forming a silica-based coating film according to [5] above wherein the proportion of component (c) is 0.001-0.5 part by weight with respect to 100 parts by weight as the total of component (a). This will further improve the surface flatness of the obtained silica-based coating film.

The invention still further relates to [7] a composition for forming a silica-based coating film according to [5] or [6] above, wherein the condensation accelerator catalyst is an onium salt. The onium salt can improve the electrical characteristics and mechanical strength of the cured composition, and is also preferred from the viewpoint of increasing the stability of the composition.

The invention still further relates to [8] a composition for forming a silica-based coating film according to any one of [5] to [7] above, wherein the aprotic solvent contains at least one aprotic solvent selected from the group consisting of ether-based solvents, ester-based solvents and ketone-based solvents.

The invention still further relates to [9] a composition for forming a silica-based coating film according to any one of [5] to [8] above, wherein the boiling point of the aprotic solvent is 80-180°C.

The invention further provides [10] a composition for forming a silica-based coating film comprising (a) a siloxane resin, (b) a solvent capable of dissolving component (a) and (c) an onium salt, wherein the proportion of component (c) is 0.001-0.5 part by weight with respect to 100 parts by weight as the total of component (a).

The present inventors have discovered that when a composition for forming a silica-based coating film containing an onium salt in a specifically proportion is applied onto a substrate having raised and indented sections on the surface, the flatness of the resulting silica-based coating film is enhanced compared to a composition for forming a silica-based coating film containing an onium salt in a proportion outside the proportion specified above. It is an essential point of the invention that the proportion of the onium salt is defined as a specific proportion.

The invention further relates to [11] a composition for forming a silica-based coating film according to any one of [5] to [10] above, wherein component (c) is an ammonium salt. Using an ammonium salt and especially a quaternary ammonium salt as the condensation accelerator catalyst can minimize the film shrinkage ratio, improve the film surface flatness, increase the stability of the composition, and enhance the electrical characteristics and mechanical properties of the silica-based coating film.

The invention further provides [12] a composition for forming a silica-based coating film according to any one

of [5] to [11] above, wherein the proportion of the (c) onium salt is 0.001-0.4 part by weight with respect to 100 parts by weight as the total of component (a).

The invention further provides [13] a composition for forming a silica-based coating film according to any one of [5] to [11] above, wherein the proportion of the (c) onium salt is 0.001-0.3 part by weight with respect to 100 parts by weight as the total of component (a).

The invention further provides [14] a composition for forming a silica-based coating film according to any one of [5] to [11] above, wherein the proportion of the (c) onium salt is 0.001-0.2 part by weight with respect to 100 parts by weight as the total of component (a).

The invention further provides [15] a composition for forming a silica-based coating film according to any one of [5] to [11] above, wherein the proportion of the (c) onium salt is 0.001-0.1 part by weight with respect to 100 parts by weight as the total of component (a).

The invention further provides [16] a composition for forming a silica-based coating film according to any one of [5] to [11] above, wherein the proportion of the (c) onium salt is 0.01-0.1 part by weight with respect to 100 parts by weight as the total of component (a).

The invention further provides [17] a composition for forming a silica-based coating film according to any one of [5] to [16] above, wherein component (a) contains a siloxane resin obtained by hydrolytic condensation of a compound represented by the following general formula (1):

$$R^1{}_nSiX_{4-n} \qquad (1)$$

[wherein $R^1$ represents an H atom or F atom, a group containing a B atom, N atom, Al atom, P atom, Si atom, Ge atom or Ti atom, or a C1-20 organic group, X represents a hydrolyzable group and n represents an integer of 0-2, with the proviso that when n is 2, each $R^1$ may be the same or different, and when n is 0-2, each X may be the same or different].

The invention still further relates to [18] a composition for forming a silica-based coating film according to [17] above, wherein component (a) contains a resin wherein the total number of one or more atoms selected from the group consisting of H atoms, F atoms, B atoms, N atoms, Al atoms, P atoms, Si atoms, Ge atoms, Ti atoms and C atoms that are bonded to each Si atom forming a siloxane bond in the siloxane resin is less than 1.0 mol.

The invention still further relates to [19] a composition for forming a silica-based coating film according to [17] above, wherein component (a) contains a resin wherein the total number of one or more atoms selected from the group consisting of H atoms, F atoms, B atoms, N atoms, Al atoms, P atoms, Si atoms, Ge atoms, Ti atoms and C atoms that are bonded to each Si atom forming a siloxane bond in the siloxane resin is no greater than 0.65 mol.

The invention still further relates to [20] a composition for forming a silica-based coating film according to any one of [5] to [19] above, which further contains a void-forming compound that undergoes thermal decomposition or volatilization at a heating temperature of 200-500°C. A composition for forming a silica-based coating film having this construction can form a silica-based coating film that is resistant to significant reduction in mechanical strength and can exhibit low permittivity.

The invention still further relates to [21] a composition for forming a silica-based coating film according to any one of [5] to [20] above, which is applied onto a substrate having raised and indented sections on the surface.

The invention still further relates to [22] a composition for forming a silica-based coating film for formation of a silica-based coating film by application onto the surface of a substrate having raised and indented sections on the surface, wherein the film thickness shrinkage ratio from the post-application applied film to the silica-based coating film obtained by curing of the applied film is no greater than 27%, and the composition for forming a silica-based coating film contains an organic solvent with a boiling point of 80°C or higher.

The invention further provides [23] a method for forming a silica-based coating film which forms a silica-based coating film on a substrate, wherein a composition for forming a silica-based coating film according to any one of [5] to [21] above is applied onto a substrate to form an applied film, the organic solvent in the applied film is removed, and the applied film is fired.

The invention further provides [24] a method for forming a silica-based coating film according to [23] above, wherein the surface of the substrate on which the composition for forming a silica-based coating film is applied has raised and indented sections.

The invention still further relates to [25] a method for forming a silica-based coating film that comprises a step of applying the composition for forming a silica-based coating film onto the surface of a substrate having raised and indented sections on the surface to form an applied film, a step of removing the organic solvent in the applied film and a step of firing the applied film after the removing step to obtain a silica-based coating film, wherein the composition for forming a silica-based coating film is subjected to condensation reaction before the step of obtaining the silica-based coating film, so that the film thickness shrinkage ratio from the applied film immediately after the step of forming the applied film, to the silica-based coating film immediately after the step of firing, is no greater than 27%.

The invention still further relates to [26] a silica-based coating film formed on a substrate by a method for

forming a silica-based coating film according to [23] or [24] above.

The invention still further relates to [27] a silica-based coating film according to [26] above, which is formed between adjacent conductive layers among a plurality of conductive layers formed on a substrate. This coating film is particularly useful when formed between adjacent conductive layers among a plurality of conductive layers formed on a substrate, that is, as an insulating film required to adequately reduce leak current, such as an interlayer insulating film.

The invention still further relates to [28] an electronic part comprising a silica-based coating film according to [26] or [27] above formed on a substrate. Such an electronic part is used to construct electronic devices such as semiconductor devices.

## Effect of the Invention

The coating film, silica-based coating film and a method for forming it, the composition for forming a silica-based coating film, and electronic parts comprising the silica-based coating film, according to the invention, allow excellent surface flatness to be realized.

## Brief Description of the Drawings

Fig. 1 is a schematic plan view showing measurement points for in-plane uniformity of film thickness.
Fig. 2 is a schematic end view showing a preferred embodiment of an electronic part according to the invention.
Fig. 3 is an end view flow chart showing a process for formation of a coating film using a conventional siloxane polymer with no reflow property as the material.
Fig. 4 is an end view flow chart showing a process for formation of a coating film using a conventional siloxane polymer with a reflow property as the material.
Fig. 5 is an end view flow chart showing a process for formation of a coating film according to the invention.
Fig. 6 is a schematic cross-sectional view for explanation of flatness.

Explanation of Symbols

1: Glass substrate, 2: undercoat film, 3: conductive layer, 4: source, 5: drain, 6: gate oxide film, 7: gate electrode, 8: first interlayer insulating film, 9: metal wiring, 10: second interlayer insulating film, 11: transparent electrode.

## Best Mode for Carrying Out the Invention

Preferred embodiments of the invention will now be explained in detail, with reference to the accompanying drawings as necessary. Throughout the drawings, corresponding elements will be referred to by like reference numerals and will be explained only once. Unless otherwise specified, the vertical and horizontal positional relationships are based on the positional relationships in the drawings. The dimensional proportions in the drawings are not restricted to the proportions shown.

For the coating film of the invention, the shrinkage ratio between the post-application coating film thickness and the post-curing, also called as post cure, coating film thickness, i.e. the film thickness shrinkage ratio from the applied film immediately application to the coating film obtained by curing of the applied film (hereinafter also referred to simply as "film shrinkage ratio") is no greater than 27%.

The shrinkage ratio of the coating film thickness, or the film shrinkage ratio, is calculated in the following manner.

(1) First, the film thickness of the coating film immediately after application, i.e.. the coated film (hereinafter also referred to as "applied film") is determined. Since the post-application film thickness of the coating film contains a solvent in most cases, the solvent may evaporate off, thereby reducing the film thickness during the application period. The post-application film thickness is the film thickness measured within 3 minutes after application.

The starting solution for the coating film, which may be, for example, the composition for forming a silica-based coating film itself, is dropped onto the center of a silicon wafer and spin coated for 30 seconds at a spin rate that produces a post-application film thickness of 400-600 nm. Next, the film thickness of the coating film is measured at three points within the plane during a period of 3 minutes, and the average value is recorded as T1. While it will depend on the conditions of the apparatus, measurement can usually be carried out easily if it is begun within, for example, 30 seconds from post-application for the first point, within 90 seconds for the second point and within 150 seconds for the third point.

(2) Next, the post-curing film thickness, i.e. the film thickness of the coating film obtained by curing of the applied

film, is determined. Here, a fresh substrate is used instead of the post-application substrate used in (1). This is because the film shrinkage ratio may differ with different standing times after application, depending on the material.

The starting solution for the coating film, for example, the composition for forming a silica-based coating film itself, is dropped onto the center of a silicon wafer and spin coated for 30 seconds with the same conditions and spin rate as in (1), and then within 30 seconds it is baked at 250°C for 3 minutes. It is then cured at 400°C for 30 minutes in a nitrogen atmosphere to obtain a cured coating film. The film thickness is measured at three points within the plane of the coating film, and the average value is recorded as T2.

Due to restrictions on the substrate and apparatus used, it is preferred to minimize the volume change even with a baking temperature of 100-350°C or a curing temperature of 300-450°C. Measurement of the film thickness is carried out, for example, in the same manner as the measurement in the examples described below. Specifically, the obtained silica-based coating film is irradiated with He-Ne laser light, and the film thickness determined from the phase contrast produced by light irradiation at a wavelength of 633 nm is measured with a spectroscopic ellipsometer (Ellipsometer L116B, trade name of Gartner, Inc.)

(3) The film shrinkage ratio T0 is determined by the following formula (A).

$$T0(\%) = (1-T2/T1) \times 100 \qquad (A)$$

The film shrinkage ratio (T0) is no greater than 27%, preferably no greater than 25% and more preferably no greater than 20% in order to yield satisfactory flatness (surface flatness) and prevent inconveniences due to film shrinkage during curing. A film shrinkage ratio exceeding 27% will tend to result in inferior flatness. A coating film formed from a composition comprising an organic solvent with a boiling point of 80°C or higher, and exhibiting a shrinkage ratio of no greater than 27% between the post-application film thickness of the coating film and the post-curing film thickness of the coating film, can fill in recesses without leaving voids and has excellent surface flatness, thus reducing the load on the Al wirings and substrates.

The composition for forming a silica-based coating film of the invention contains components (a)-(c) as explained hereunder, but it is a characteristic feature of the invention that the composition for forming a silica-based coating film contains at least one aprotic solvent as component (b) and a condensation accelerator catalyst as component (c). The components of the composition for forming a silica-based coating film of the invention will now be explained in detail.

<Component (a)>

According to the invention, the siloxane resin used as component (a) functions as the coating film-forming component for the silica-based coating film described below. In order to exhibit this function, the composition for forming a silica-based coating film of the invention preferably contains as component (a) a siloxane resin obtained by hydrolytic condensation of a compound represented by formula (1) below.

$$R^1_nSiX_{4-n} \qquad (1)$$

In general formula (1), $R^1$ represents an H atom or F atom, a group containing a B atom, N atom, Al atom, P atom, Si atom, Ge atom or Ti atom, or a C1-20 organic group (preferably a C1-12 and more preferably a C1-6 organic group).

Also, the total number (M) of one or more atoms selected from the group consisting of H atoms, F atoms, B atoms, N atoms, Al atoms, P atoms, Si atoms, Ge atoms, Ti atoms and C atoms that are bonded to each Si atom forming a siloxane bond in the siloxane resin (hereinafter referred to as "specified bonding atoms") is preferably less than 1.0, more preferably no greater than 0.7, even more preferably no greater than 0.65 and most preferably no greater than 0.5. The lower limit for M is preferably about 0.20.

If the value of M exceeds 1.0, the finally obtained silica-based coating film will tend to have poor adhesion with other films (layers) and mechanical strength. On the other hand, if the value of M is less than 0.20 the film will tend to have an inferior dielectric characteristic when used as an insulating film. From the viewpoint of the film formability of the silica-based coating film, the siloxane resin more preferably contains, among the specified bonding atoms mentioned above, one or more atoms selected from the group consisting of H atoms, F atoms, N atoms, Si atoms, Ti atoms and C atoms, among which it even more preferably contains one or more atoms selected from the group consisting of H atoms, F atoms, N atoms, Si atoms and C atoms from the viewpoint of the dielectric characteristic and mechanical strength.

The value of M can be determined from the charging mass of the compound represented by general formula (1) above used as the siloxane resin starting material. For example, it may be calculated using the following formula (B).

$$M = [M1 + (M2/2) + (M3/3)]/MSi \quad (B)$$

In this formula, M1 represents the number of atoms bonded to a single (only one) silicon (Si) atom among the specified bonding atoms, M2 represents the number of atoms shared by two silicon atoms among the specified bonding atoms, M3 represents the number of atoms shared by three silicon atoms among the specified bonding atoms, and MSi represents the total number of silicon atoms.

For example, the value of M for a resin obtained by charging and hydrolytic condensation of 154.6 g of tetraethoxysilane (TEOS) and 120.6 g of methyltriethoxysilane (MTES) is calculated as follows.
TEOS charging mass = 154.6 g
MTES charging mass = 120.6 g
TEOS molecular weight = 208.3 g/mol
MTES molecular weight = 178.3 g/mol

$$M = \{(120.6/178.3) \times 6.02 \times 10^{23}\}/\{(154.6/208.3) + (120.6/178.3) \times 6.02 \times 10^{23}\} = 0.48$$

X in general formula (1) represents a hydrolyzable group. As examples of X there may be mentioned alkoxy, aryloxy, halogen atoms, acetoxy, isocyanate and hydroxyl, among which alkoxy and aryloxy are preferred and alkoxy is more preferred. If X is an alkoxy group, the composition will exhibit superior liquid stability and coating characteristics.

It is conjectured that a greater number of hydrolyzable groups such as alkoxy groups in the siloxane resin will tend to increase the film shrinkage ratio from applied film to silica-based coating film, while a smaller number of hydrolyzable groups will tend to decrease the film shrinkage ratio. Thus, it is preferred to minimize the proportion of hydrolyzable groups in the siloxane resin in order to reduce the film shrinkage ratio to the silica-based coating film.

As compounds represented by the general formula (1) wherein the hydrolyzable group X is an alkoxy group, there may be mentioned tetraalkoxysilanes, trialkoxysilanes, dialkoxysilanes and the like, which may also be substituted.

Examples of tetraalkoxysilanes include tetramethoxysilane, tetraethoxysilane, tetra-n-propoxysilane, tetra-iso-propoxysilane, tetra-n-butoxysilane, tetra-sec-butoxysilane, tetra-tert-butoxysilane and the like.

As trialkoxysilanes there may be mentioned trimethoxysilane, triethoxysilane, tri-n-propoxysilane, fluorotrimethoxysilane, fluorotriethoxysilane, fluorotri-n-propoxysilane, methyltrimethoxysilane, methyltriethoxysilane, methyltri-n-propoxysilane, methyltri-iso-propoxysilane, methyltri-n-butoxysilane, methyltri-iso-butoxysilane, methyltri-tert-butoxysilane, ethyltrimethoxysilane, ethyltriethoxysilane, ethyltri-n-propoxysilane, ethyltri-iso-propoxysilane, ethyltri-n-butoxysilane, ethyltri-iso-butoxysilane, ethyltri-tert-butoxysilane, n-propyltrimethoxysilane, n-propyltriethoxysilane, n-propyltri-n-propoxysilane, n-propyltri-iso-propoxysilane, n-propyltri-n-butoxysilane, n-propyltri-iso-butoxysilane, n-propyltri-tert-butoxysilane, iso-propyltrimethoxysilane, iso-propyltriethoxysilane, iso-propyltri-n-propoxysilane, iso-propyltriiso-propoxysilane, iso-propyltri-n-butoxysilane, iso-propyltri-iso-butoxysilane, iso-propyltri-tert-butoxysilane, n-butyltrimethoxysilane, n-butyltriethoxysilane, n-butyltri-n-propoxysilane, n-butyltri-iso-propoxysilane, n-butyltri-n-butoxysilane, n-butyltri-iso-butoxysilane, n-butyltri-tert-butoxysilane, sec-butyltrimethoxysilane, sec-butyltriethoxysilane, sec-butyltri-n-propoxysilane, sec-butyltri-iso-propoxysilane, sec-butyltri-n-butoxysilane, sec-butyltri-iso-butoxysilane, sec-butyltri-tert-butoxysilane, t-butyltrimethoxysilane, t-butyltriethoxysilane, t-butyltri-n-propoxysilane, t-butyltri-iso-propoxysilane, t-butyltri-n-butoxysilane, t-butyltri-iso-butoxysilane, t-butyltri-tert-butoxysilane, phenyltrimethoxysilane, phenyltriethoxysilane, phenyltri-n-propoxysilane, phenyltri-iso-propoxysilane, phenyltri-n-butoxysilane, phenyltri-iso-butoxysilane, phenyltri-tert-butoxysilane, trifluoromethyltrimethoxysilane, pentafluoroethyltrimethoxysilane, 3,3,3-trifluoropropyltrimethoxysilane and 3,3,3-trifluoropropyltriethoxysilane.

As dialkoxysilanes there may be mentioned methyldimethoxysilane, methyldiethoxysilane, dimethyldimethoxysilane, dimethyldiethoxysilane, dimethyldi-n-propoxysilane, dimethyldi-iso-propoxysilane, dimethyldi-n-butoxysilane, dimethyldi-sec-butoxysilane, dimethyldi-tert-butoxysilane, diethyldimethoxysilane, diethyldiethoxysilane, diethyldi-n-propoxysilane, diethyldi-iso-propoxysilane, diethyldi-n-butoxysilane, diethyldi-sec-butoxysilane, diethyldi-tert-butoxysilane, di-n-propyldimethoxysilane, di-n-propyldiethoxysilane, di-n-propyldi-n-propoxysilane, di-n-propyldi-iso-propoxysilane, di-n-propyldi-n-butoxysilane, di-n-propyldi-sec-butoxysilane, di-n-propyldi-tert-butoxysilane, di-iso-propyldimethoxysilane, di-iso-propyldiethoxysilane, di-iso-propyldi-n-propoxysilane, di-iso-propyldi-iso-propoxysilane, di-iso-propyldi-n-butoxysilane, di-iso-propyldi-sec-butoxysilane, di-iso-propyldi-tert-butoxysilane, di-n-butyldimethoxysilane, di-n-butyldiethoxysilane, di-n-butyldi-n-propoxysilane, di-n-butyldi-iso-propoxysilane, di-n-butyldi-n-butoxysilane, di-n-butyldi-sec-butoxysilane, di-n-butyldi-tert-butoxysilane, di-sec-butyldimethoxysilane, di-sec-butyldiethoxysilane, di-sec-butyldi-n-propoxysilane, di-sec-butyldi-iso-propoxysilane, di-sec-butyldi-n-butoxysilane, di-sec-butyldi-sec-butoxysilane, di-sec-butyldi-tert-butoxysilane, di-tert-butyldimethoxysilane, di-tert-butyldiethoxysilane, di-tert-butyldi-n-propoxysilane, di-tert-butyldi-iso-propoxysilane, di-tert-butyldi-n-butoxysilane, di-tert-butyldi-sec-butoxysilane, di-tert-butyldi-tert-butoxysilane, diphenyldimethoxysilane, diphenyldiethoxysilane, diphenyldi-n-propoxysilane, diphenyldi-iso-propoxysilane, diphenyldi-n-butoxysilane, diphenyldi-sec-butoxysilane, diphenyldi-tert-butoxysilane, bis(3,3,3-trifluoropropyl)dimethoxysilane and methyl(3,3,3-trifluoropropyl)dimethoxysilane.

As examples of compounds other than those mentioned above for compounds of general formula (1) wherein $R^1$ is a C1-20 organic group, there may be mentioned bissilylalkanes and bissilylbenzenes, such as bis(trimethoxysilyl)methane, bis(triethoxysilyl)methane, bis(tri-n-propoxysilyl)methane, bis(tri-iso-propoxysilyl)methane, bis(trimethoxysilyl)ethane, bis(triethoxysilyl)ethane, bis(tri-n-propoxysilyl)ethane, bis(tri-iso-propoxysilyl)ethane, bis(trimethoxysilyl)propane, bis(triethoxysilyl)propane, bis(tri-n-propoxysilyl)propane, bis(tri-iso-propoxysilyl)propane, bis(trimethoxysilyl)benzene, bis(triethoxysilyl)benzene, bis(tri-n-propoxysilyl)benzene and bis(tri-iso-propoxysilyl)benzene.

As examples of compounds of general formula (1) wherein $R^1$ is a group containing a Si atom there may be mentioned hexaalkoxydisilanes such as hexamethoxydisilane, hexaethoxydisilane, hexa-n-propoxydisilane and hexa-iso-propoxydisilane, and dialkyltetraalkoxydisilanes such as 1,2-dimethyltetramethoxydisilane, 1,2-dimethyltetraethoxydisilane and 1,2-dimethyltetrapropoxydisilane.

As compounds represented by general formula (1) wherein the hydrolyzable group X is an aryloxy group, there may be mentioned tetraaryloxysilanes, triaryloxysilanes, diaryloxysilanes and the like, which may also be substituted. As an example of a tetraaryloxysilane there may be mentioned tetraphenoxysilane. As examples of triaryloxysilanes there may be mentioned triphenoxysilane, methyltriphenoxysilane, ethyltriphenoxysilane, n-propyltriphenoxysilane, iso-propyltriphenoxysilane, n-butyltriphenoxysilane, sec-butyltriphenoxysilane, t-butyltriphenoxysilane, phenyltriphenoxysilane and the like. As examples of diaryloxysilanes there may be mentioned dimethyldiphenoxysilane, diethyldiphenoxysilane, di-n-propyldiphenoxysilane, di-iso-propyldiphenoxysilane, di-n-butyldiphenoxysilane, di-sec-butyldiphenoxysilane, di-tert-butyldiphenoxysilane, diphenyldiphenoxysilane and the like.

Examples of compounds represented by general formula (1) wherein X is a halogen atom (halogen group) (i.e., halogenated silanes) include compounds which are the aforementioned alkoxysilanes having the alkoxy groups replaced by halogen atoms. As compounds represented by general formula (1) wherein X is an acetoxy group (i.e. acetoxysilanes) there may be mentioned the aforementioned alkoxysilanes having the alkoxy groups replaced by acetoxy groups. As compounds represented by general formula (1) wherein X is an isocyanate group (i.e. isocyanatosilanes) there may be mentioned the aforementioned alkoxysilanes having the alkoxy groups replaced by isocyanate groups. As compounds represented by general formula (1) wherein X is a hydroxyl group (i.e. hydroxysilanes) there may be mentioned the aforementioned alkoxysilanes having the alkoxy groups replaced by hydroxyl groups. The compounds represented by formula (1) above may be used alone or in combinations of two or more.

There may also be used a resin obtained by hydrolytic condensation of a partial condensation product such as a multimer of a compound represented by general formula (1), a resin obtained by hydrolytic condensation between a partial condensation product such as a multimer of a compound represented by general formula (1) and a compound represented by general formula (1), a resin obtained by hydrolytic condensation between a compound represented by general formula (1) and another compound, or a resin obtained by hydrolytic condensation between a partial condensation product such as a multimer of a compound represented by general formula (1), a compound represented by general formula (1) and the "other compound".

As examples of partial condensation products such as multimers of compounds represented by general formula (1) there may be mentioned hexaalkoxydisiloxanes such as hexamethoxydisiloxane, hexaethoxydisiloxane, hexa-n-propoxydisiloxane and hexa-iso-propoxydisiloxane, or trisiloxane, tetrasiloxane and oligosiloxanes that have undergone partial condensation.

As examples of "other compounds" there may be mentioned compounds with polymerizable double bonds or triple bonds. As examples of compounds with polymerizable double bonds there may be mentioned ethylene, propylene, isobutene, butadiene, isoprene, vinyl chloride, vinyl acetate, vinyl propionate, vinyl caproate, vinyl stearate, methylvinyl ether, ethylvinyl ether, propylvinyl ether, acrylonitrile, styrene, methacrylic acid, methyl methacrylate, ethyl methacrylate, n-propyl methacrylate, iso-propyl methacrylate, n-butyl methacrylate, acrylic acid, methyl acrylate, ethyl acrylate, phenyl acrylate, vinylpyridine, vinylimidazole, acrylamide, allylbenzene, diallylbenzene, and partial condensation products of these compounds. As compounds with triple bonds there may be mentioned acetylene, ethynylbenzene and the like.

The resin obtained in this manner may be used alone, or two or more thereof may be used in combination. As a method of combining two or more different siloxane resins there may be mentioned, for example, a method of combining two or more siloxane resins with different weight-average molecular weights, and a method of combining two or more siloxane resins obtained by hydrolytic condensation of different compounds as the essential components.

In general formula (1), n represents an integer of 0-2. This is with the proviso that when n is 2, each $R^1$ may be the same or different. Also, when n is 0-2, each X may be the same or different. The value of n is preferably 0-1, and preferably there is used a combination of a compound represented by general formula (1) wherein n is 0 and a compound

represented by general formula (1) wherein n is 1. When a combination of compounds wherein n is 0 and 1 is used, the siloxane resin will contain a unit represented by $SiO_2$ and a unit represented by $R^1SiO_{3/2}$. Here, $R^1$ has the same definition as above. The siloxane resin is obtained by co-hydrolytic condensation of the aforementioned polyfunctional tetraalkoxysilane and trialkoxysilane. The unit represented by $SiO_2$ is a unit derived from the tetraalkoxysilane, while the unit represented by $R^1SiO_{3/2}$ is a unit derived from the trialkoxysilane. Since a siloxane resin containing such units has improved the crosslink density, the coating film properties can be enhanced.

A catalyst is preferably also used for the hydrolytic condensation of the compound represented by general formula (1). As examples of such catalysts there may be mentioned acid catalysts, alkali catalysts, metal chelate compounds and the like.

As examples of acid catalysts there may be mentioned organic acids such as formic acid, maleic acid, fumaric acid, phthalic acid, malonic acid, succinic acid, tartaric acid, malic acid, lactic acid, citric acid, acetic acid, propionic acid, butanoic acid, pentanoic acid, hexanoic acid, heptanoic acid, octanoic acid, nonanoic acid, decanoic acid, oxalic acid, adipic acid, sebacic acid, butyric acid, oleic acid, stearic acid, linoleic acid, linoleic acid, salicylic acid, benzenesulfonic acid, benzoic acid, p-aminobenzoic acid, p-toluenesulfonic acid, methanesulfonic acid, trifluoromethanesulfonic acid and trifluoroethanesulfonic acid, and inorganic acids such as hydrochloric acid, phosphoric acid, nitric acid, boric acid, sulfuric acid and hydrofluoric acid. They may be used alone or in combinations of two or more.

As examples of alkali catalysts there may be mentioned sodium hydroxide, potassium hydroxide, rubidium hydroxide, cesium hydroxide, pyridine, monoethanolamine, diethanolamine, triethanolamine, dimethylmonoethanolamine, monomethyldiethanolamine, ammonia, tetramethylammonium hydroxide, tetraethylammonium hydroxide, tetrapropylammonium hydroxide, methylamine, ethylamine, propylamine, butylamine, pentylamine, hexylamine, heptylamine, octylamine, nonylamine, decylamine, undecasylamine, dodecasylamine, cyclopentylamine, cyclohexylamine, N,N-dimethylamine, N,N-diethylamine, N,N-dipropylamine, N,N-dibutylamine, N,N-dipentylamine, N,N-dihexylamine, N, N-dicyclopentylamine, N,N-dicyclohexylamine, trimethylamine, triethylamine, tripropylamine, tributylamine, tripentylamine, trihexylamine, tricyclopentylamine, tricyclohexylamine and the like. These may be used alone or in combinations of two or more.

As examples of metal chelate compounds there may be mentioned titanium-containing metal chelate compounds such as trimethoxy-mono(acetylacetonato)titanium, triethoxy-mono(acetylacetonato)titanium, tri-n-propoxy-mono(acetylacetonato)titanium, tri-iso-propoxy-mono(acetylacetonato)titanium, tri-n-butoxy-mono(acetylacetonato)titanium, tri-sec-butoxy-mono(acetylacetonato)titanium, tri-tert-butoxy-mono(acetylacetonato)titanium, dimethoxy-di(acetylacetonato)titanium, diethoxy-di(acetylacetonato)titanium, din-propoxy-di(acetylacetonato)titanium, di-iso-propoxy-di (acetylacetonato)titanium, di-n-butoxy-di(acetylacetonato)titanium, di-sec-butoxy-di(acetylacetonato)titanium, di-tert-butoxy-di(acetylacetonato)titanium, monomethoxy-tris(acetylacetonato)titanium, monoethoxy-tris(acetylacetonato)titanium, mono-n-propoxy-tris(acetylacetonato)titanium, mono-iso-propoxy-tris(acetylacetonato)titanium, mono-n-butoxy-tris(acetylacetonato)titanium, mono-sec-butoxy-tris(acetylacetonato)titanium, mono-tert-butoxy-tris(acetylacetonato)titanium, tetrakis(acetylacetonato)titanium, trimethoxy-mono(ethylacetoacetate)titanium, triethoxy-mono(ethylacetoacetate)titanium, tri-n-propoxy-mono(ethylacetoacetate)titanium, tri-iso-propoxy-mono(ethylacetoacetate)titanium, tri-n-butoxy-mono(ethylacetoacetate)titanium, tri-sec-butoxy-mono(ethylacetoacetate)titanium, tri-tert-butoxy-mono(ethylacetoacetate)titanium, dimethoxy-di(ethylacetoacetate)titanium, diethoxy-di(ethylacetoacetate)titanium, di-n-propoxy-di (ethylacetoacetate)titanium, di-iso-propoxy-di(ethylacetoacetate)titanium, di-n-butoxy-di(ethylacetoacetate)titanium, di-sec-butoxy-di(ethylacetoacetate)titanium, di-tert-butoxy-di(ethylacetoacetate)titanium, monomethoxy-tris(ethylacetoacetate)titanium, monoethoxy-tris(ethylacetoacetate)titanium, mono-n-propoxy-tris(ethylacetoacetate)titanium, mono-iso-propoxy-tris(ethylacetoacetate)titanium, mono-n-butoxy-tris(ethylacetoacetate)titanium, mono-sec-butoxy-tris(ethylacetoacetate)titanium, mono-tert-butoxy-tris(ethylacetoacetate)titanium, tetrakis(ethylacetoacetate)titanium and the like, as well as these titanium-containing metal chelate compounds wherein the titanium is replaced by zirconium, aluminum or the like. These may likewise be used alone or in combinations of two or more.

In the hydrolytic condensation of the compound represented by general formula (1), the aforementioned catalyst is preferably used for the hydrolysis. However, when the stability of the composition is poor or when addition of the catalyst can potentially cause corrosion of the other materials, the catalyst may be removed from the composition after hydrolysis or it may be reacted to render the catalytic function inactive. There are no particular restrictions on the method of removal or reaction, but the removal may be accomplished using distillation or ion chromatography column. The hydrolysate obtained from general formula (1) may be removed from the composition by reprecipitation or the like. The method for inactivating the function of the catalyst by reaction, if the catalyst is an alkali catalyst, for example, may be a method wherein an acid catalyst is added for neutralization or to shift the pH toward the acidic end.

The amount of catalyst used is preferably in the range of 0.0001-1 mol with respect to 1 mol of the compound represented by general formula (1). Using an amount of less than 0.0001 mol will tend to essentially prevent the reaction from proceeding, while using an amount of greater than 1 mol will tend to promote gelling during the hydrolytic condensation.

Also, since alcohol by-products of the hydrolysis reaction are protic solvents, they are preferably removed using

an evaporator or the like.

From the viewpoint of solubility, mechanical properties and moldability, the resin has a weight-average molecular weight of preferably 500-1,000,000, more preferably 500-500,000, even more preferably 500-100,000, yet more preferably 500-20,000, very preferably 500-10,000 and most preferably 500-5000, as measured by gel permeation chromatography (hereinafter, "GPC") and calculated using a standard polystyrene calibration curve. A weight-average molecular weight of less than 500 will tend to result in inferior film formability of the cured composition, while a weight-average molecular weight exceeding 1,000,000 will tend to lower compatibility with the solvent. A larger molecular weight of the siloxane resin will tend to reduce the film shrinkage ratio from the applied film to the silica-based coating film. Thus, it is preferred to increase the molecular weight of the siloxane resin in order to reduce the film shrinkage ratio.

According to the invention, the weight-average molecular weight is measured by gel permeation chromatography (hereinafter, ""GPC") and calculated using a standard polystyrene calibration curve.

The weight-average molecular weight (Mw) may be measured by GPC under the following conditions, for example.

Sample volume: 10 μL
Standard polystyrene: Standard polystyrene by Tosoh Corp. (molecular weights: 190,000, 17,900, 9100, 2980, 578, 474, 370, 266)
Detector: L-3000 RI-monitor by Hitachi, Ltd.
Integrator: D-2200 GPC integrator by Hitachi, Ltd.
Pump: L-6000 by Hitachi, Ltd.
Degassing apparatus: Shodex DEGAS by Showa Denko K.K.
Column: Columns GL-R440, GL-R430, GL-R420 by Hitachi Chemical Co., Ltd. were used in concatenation in that order.
Eluent: Tetrahydrofuran (THF)
Measuring temperature: 23°C
Flow rate: 1.75 mL/min
Measuring time: 45 minutes

The amount of water used for the hydrolytic condensation reaction may be appropriately determined, but the amount of water is preferably a value with the range of 0.1-20 mol with respect to 1 mol of hydrolyzable groups such as alkoxy groups in the compound represented by general formula (1). If the amount of water is less than 0.1 mol or greater than 20 mol, the film formability of the silica-based coating film will tend to be impaired, and the shelf life of the composition itself will tend to be shortened.

The amount of water is preferably 0.1-1000 mol, more preferably 0.5-100 mol and most preferably 0.5-20 mol per 1 mole of the compound represented by general formula (1). If the amount of water is less than 0.1 mol, the hydrolytic condensation reaction may not proceed adequately, while if the amount of water is greater than 1000 mol, gelled substances will tend to be produced during hydrolysis or condensation.

<Component (b)>

Protic solvents such as alcohol have hydrogen atoms bonded to highly electronegative oxygen atoms. Protic solvent molecules therefore solvate nucleophilic reagents and the like by hydrogen bonding. Specifically, since the protic solvent solvates the siloxane resin obtained by hydrolysis of the compound represented by general formula (1), the solvent molecules must be removed to accomplish condensation of the siloxane resin, while they also tend to interfere with curing at low temperature. Consequently, large amounts of the solvent can remain in the post-application coating film, tending to increase the film shrinkage ratio during curing. On the other hand, an aprotic solvent is a solvent without any hydrogen atoms on large electronegative elements, and therefore presumably they produce less reaction inhibition than protic solvents. With aprotic solvents, therefore, condensation reaction of the siloxane proceeds to some extend in the post-application coating film, and very little of the solvent is present in the coating film.

Component (b) is an organic solvent that dissolves the siloxane resin used as component (a) and lowers its viscosity in order to facilitate its handling. If the proportion of the protic solvent in the organic solvent is high, the film shrinkage ratio from the applied film to the silica-based coating film will tend to be increased, while increasing the aprotic solvent proportion will tend to reduce the film shrinkage ratio. The proportion of aprotic solvent is therefore preferably high to reduce the film shrinkage ratio. The film shrinkage ratio can be reduced by specifying a minimum level for the aprotic solvent.

In order to exhibit this function, the composition for forming a silica-based coating film of the invention contains an aprotic solvent at 30 wt% or greater, preferably 50 wt% or greater, more preferably 70 wt% or greater, even more preferably 80 wt% or greater and most preferably 90 wt% or greater based on the weight of component (b). A low proportion of aprotic solvent in component (b) may increase the film shrinkage ratio during curing of the composition and make it difficult to have achieve curing at a low temperature and in a shorter time period. It may also increase the relative permittivity and lower the mechanical strength of the coating film.

As aprotic solvents there may be mentioned ketone-based solvents, ether-based solvents, ester-based solvents, nitrile-based solvents, amide-based solvents and sulfoxide-based solvents. Preferred among these are ketone-based solvents, ether-based solvents and ester-based solvents. Among ether-based solvents there are preferred dialkyl esters of dihydric alcohols, diesters of dihydric alcohols, and alkyl esters of dihydric alcohols. Among ester-based solvents there are preferred the diesters of dihydric alcohols and alkyl esters of dihydric alcohols listed above for ether-based solvents, as well as alkyl acetates.

Particularly preferred from the viewpoint of compatibility with the siloxane resin and mechanical strength of the silica-based coating film are diethyleneglycol dimethyl ether, propyleneglycol monomethyl ether acetate and cyclohexanone.

The boiling point of the solvent is preferably 80°C or higher, and more preferably 80-180°C. It is even more preferably 100°C-180°C. It is yet more preferably 100-160°C, and most preferably 120°C-160°C. The boiling point of the solvent is preferably low in order to reduce the film thickness immediately after film formation and minimize the film shrinkage ratio in the curing process. The mechanism for this is not fully understood, but a solvent boiling point of below 80°C will tend to produce film irregularities such as striations during film formation, thus tending to impair the uniformity of film thickness in the plane immediately after curing. If the boiling point of the solvent is above 180°C, it will tend to remain in the post-application coating film and increase the film shrinkage ratio. Such solvents may be used alone or in combinations of two or more.

From the viewpoint of further minimizing film irregularities and further improving the film thickness uniformity, it is preferred for one or more organic solvents with boiling points of 80°C or higher to be in the highest proportion in the organic solvent of component (b). Specifically, the content of one or more organic solvents with boiling points of 80°C or higher is preferably at least 50 wt%, more preferably at least 75 wt%, even more preferably at least 80 wt% and most preferably 90 wt% with respect to the total amount of component (b).

As ketone-based solvents there may be mentioned acetone, methyl ethyl ketone, methyl-n-propylketone, methyl-iso-propylketone, methyl-n-butylketone, methyl-iso-butylketone, methyl-n-pentylketone, methyl-n-hexylketone, diethylketone, dipropylketone, di-iso-butylketone, trimethylnonanone, cyclohexanone, cyclopentanone, methylcyclohexanone, 2,4-pentanedione, acetonylacetone, γ-butyrolactone and γ-valerolactone.

As ether-based solvents there may be mentioned diethyl ether, methylethyl ether, methyl-n-di-n-propyl ether, di-iso-propyl ether, tetrahydrofuran, methyltetrahydrofuran, dioxane, dimethyldioxane, ethyleneglycol dimethyl ether, ethyleneglycol diethyl ether, ethyleneglycol di-n-propyl ether, ethyleneglycol dibutyl ether, diethyleneglycol dimethyl ether, diethyleneglycol diethyl ether, diethyleneglycol methylethyl ether, diethyleneglycol methyl mono-n-propyl ether, diethyleneglycol methyl mono-n-butyl ether, diethyleneglycol di-n-propyl ether, diethyleneglycol di-n-butyl ether, diethyleneglycol methyl mono-n-hexyl ether, triethyleneglycol dimethyl ether, triethyleneglycol diethyl ether, triethyleneglycol methylethyl ether, triethyleneglycol methyl mono-n-butyl ether, triethyleneglycol di-n-butyl ether, triethyleneglycol methyl mono-n-hexyl ether, tetraethyleneglycol dimethyl ether, tetraethyleneglycol diethyl ether, tetradiethyleneglycol methylethyl ether, tetraethyleneglycol methyl mono-n-butyl ether, diethyleneglycol di-n-butyl ether, tetraethyleneglycol methyl mono-n-hexyl ether, tetraethyleneglycol di-n-butyl ether, propyleneglycol dimethyl ether, propyleneglycol diethyl ether, propyleneglycol di-n-propyl ether, propyleneglycol dibutyl ether, dipropyleneglycol dimethyl ether, dipropyleneglycol diethyl ether, dipropyleneglycol methylethyl ether, dipropyleneglycol methyl mono-n-butyl ether, dipropyleneglycol di-n-propyl ether, dipropyleneglycol di-n-butyl ether, dipropyleneglycol methyl mono-n-hexyl ether, tripropyleneglycol dimethyl ether, tripropyleneglycol diethyl ether, tripropyleneglycol methylethyl ether, tripropyleneglycol methyl mono-n-butyl ether, tripropyleneglycol di-n-butyl ether, tripropyleneglycol methyl mono-n-hexyl ether, tetrapropyleneglycol dimethyl ether, tetrapropyleneglycol diethyl ether, tetradipropyleneglycol methylethyl ether, tetrapropyleneglycol methyl mono-n-butyl ether, dipropyleneglycol di-n-butyl ether, tetrapropyleneglycol methyl mono-n-hexyl ether and tetrapropyleneglycol di-n-butyl ether.

As ester-based solvents there may be mentioned methyl acetate, ethyl acetate, n-propyl acetate, i-propyl acetate, n-butyl acetate, i-butyl acetate, sec-butyl acetate, n-pentyl acetate, sec-pentyl acetate, 3-methoxybutyl acetate, methylpentyl acetate, 2-ethylbutyl acetate, 2-ethylhexyl acetate, benzyl acetate, cyclohexyl acetate, methylcyclohexyl acetate, nonyl acetate, methyl acetoacetate, ethyl acetoacetate, diethyleneglycol acetate monomethyl ether, diethyleneglycol acetate monoethyl ether, diethyleneglycol acetate mono-n-butyl ether, dipropyleneglycol acetate monomethyl ether, dipropyleneglycol acetate monoethyl ether, diglycol acetate, methoxytriglycol acetate, ethyl propionate, n-butyl propionate, i-amyl propionate, diethyl oxalate and di-n-butyl oxalate.

As ether acetate-based solvents there may be mentioned ethyleneglycol methyl ether propionate, ethyleneglycol ethyl ether propionate, ethyleneglycol methyl ether acetate, ethyleneglycol ethyl ether acetate, diethyleneglycol methyl ether acetate, diethyleneglycol ethyl ether acetate, diethylene glycol-n-butyl ether acetate, propyleneglycol methyl ether acetate, propyleneglycol ethyl ether acetate, propyleneglycol propyl ether acetate, dipropyleneglycol methyl ether acetate and dipropyleneglycol ethyl ether acetate.

As amide-based solvents there may be mentioned acetonitrile, N-methylpyrrolidinone, N-ethylpyrrolidinone, N-propylpyrrolidinone, N-butylpyrrolidinone, N-hexylpyrrolidinone, N-cyclohexylpyrrolidinone, N,N-dimethylformamide,

N,N-dimethylacetamide and N,N-dimethylsulfoxide.

These may be used alone or in combinations of two or more.

In terms of the stability of the composition for forming a silica-based coating film, component (b) is preferably soluble in water or dissolves water, and more preferably it is both soluble in water and dissolves water. Also, the solvent is preferably a polar solvent. If the solvent is non-polar, it will tend to have poor compatibility with component (a), possibly leading to problems with stability of the solution. Thus, when the aprotic solvent is not soluble in water or does not dissolve water, it is preferred to add a protic solvent. If the aprotic solvent is not soluble in water or does not dissolve water, and no protic solvent is included, the compatibility with the solvent of component (a) will tend to be lower and the stability will tend to be reduced. However, if stability can be sacrificed to some degree for the sake of flatness, it may be advantageous to use less of the protic solvent.

If necessary, a protic solvent component may also be included other than in component (b). Examples of such protic solvents include alcohol-based solvents, ether-based solvents and ester-based solvents.

As alcohol-based solvents there may be mentioned methanol, ethanol, n-propanol, i-propanol, n-butanol, i-butanol, sec-butanol, t-butanol, n-pentanol, i-pentanol, 2-methylbutanol, sec-pentanol, t-pentanol, 3-methoxybutanol, n-hexanol, 2-methylpentanol, sec-hexanol, 2-ethylbutanol, sec-heptanol, n-octanol, 2-ethylhexanol, sec-octanol, n-nonyl alcohol, n-decanol, sec-undecyl alcohol, trimethylnonyl alcohol, sec-tetradecyl alcohol, sec-heptadecyl alcohol, phenol, cyclohexanol, methylcyclohexanol, benzyl alcohol, ethylene glycol, 1,2-propyleneglycol, 1,3-butyleneglycol, diethylene glycol, dipropyleneglycol, triethylene glycol, tripropyleneglycol and the like.

As ether-based solvents there may be mentioned ethyleneglycol methyl ether, ethyleneglycol ethyl ether, ethyleneglycol monophenyl ether, diethyleneglycol monomethyl ether, diethyleneglycol monoethyl ether, diethyleneglycol mono-n-butyl ether, diethyleneglycol mono-n-hexyl ether, ethoxytriglycol, tetraethyleneglycol mono-n-butyl ether, dipropyleneglycol monomethyl ether, dipropyleneglycol monoethyl ether, tripropyleneglycol monomethyl ether and the like.

As examples of ester-based solvents there may be mentioned methyl lactate, ethyl lactate, n-butyl lactate, n-amyl lactate and the like.

These may be used alone or in combinations of two or more, and they are preferably used together with an aprotic solvent.

There are no particular restrictions on the method of using component (b), but examples include a method of using it as a solvent for preparation of component (a), a method of first preparing component (b) and then adding it, a method of solvent exchange, and a method of adding the solvent (b) after removing component (a) by solvent distillation or the like.

<Component (c)>

In order to exhibit its function, the composition for forming a silica-based coating film of the invention preferably contains a condensation accelerator catalyst as component (c). Component (c) has the function of increasing the stability of the composition for forming a silica-based coating film while reducing the film shrinkage ratio of the silica-based coating film and improving the electrical characteristics and mechanical properties. It is also thought that it accelerates condensation reaction of component (a), reduces the film shrinkage ratio and permits a lower curing temperature and shorter curing time, and helps to further inhibit reduction in mechanical strength.

A compound is judged as having "condensation accelerator catalyst activity", i.e. as being a condensation accelerator catalyst, in the following manner.

(1) First, a composition comprising components (a) and (b) is prepared.

(2) Next, the post-application film thickness of the composition is determined. Since the post-application film thickness of the coating film contains a solvent in most cases, the solvent may evaporate off during the application period, thereby reducing the film thickness. The post-application film thickness is the film thickness measured within 3 minutes after application.

The composition for forming a silica-based coating film, is dropped onto the center of a silicon wafer and spin coated for 30 seconds at a spin rate giving a post-application film thickness of 400-600 nm. Next, the film thickness is measured at 3 points in the plane within 3 minutes and the average value is recorded as T3. For example, although it will depend on the conditions of the apparatus, measurement can usually be carried out easily if measurement is begun within 30 seconds from post-application for the first point, within 90 seconds for the second point and within 150 seconds for the third point.

(3) Next, the compound which is to be examined for condensation accelerator catalyst activity is added to the composition in an amount of 0.1 wt% with respect to the total amount of component (a) to obtain a new composition, and this composition is used in step (2) above to determine the post-application film thickness T4.

If addition of the compound being examined for condensation accelerator catalyst activity produces a post-application film thickness which is at least 5% smaller than before addition of the compound, i.e. if T3 and T4 satisfy the condition represented by the following formula (C):

$$(1\text{-}T4/T3) \times 100 \geq 5 \quad (C),$$

then the compound is judged as having condensation accelerator catalyst activity.

As examples of condensation accelerator catalysts for component (c) there may be mentioned alkali metals with condensation accelerator catalyst activity such as sodium hydroxide, sodium chloride, potassium hydroxide and potassium chloride, as well as onium salts. These may be used alone or in combinations of two or more.

From the standpoint of improving the electrical characteristics and mechanical strength of the cured composition and increasing the composition stability, component (c) is preferably an onium salt with condensation accelerator catalyst activity, and more preferably it is an ammonium salt and especially a quaternary ammonium salt with condensation accelerator catalyst activity.

Addition of an onium salt to the composition for forming a silica-based coating film will tend to reduce the film shrinkage ratio from the applied film to the silica-based coating film. An onium salt is therefore added to the composition to reduce the film shrinkage ratio.

As an example of an onium salt there may be mentioned a salt formed from (c-1) a nitrogen-containing compound and (c-2) at least one selected from among anionic group-containing compounds and halogen atoms. The atom bonding with the nitrogen of the (c-1) nitrogen-containing compound is preferably at least one atom selected from the group consisting of H atoms, F atoms, B atoms, N atoms, Al atoms, P atoms, Si atoms, Ge atoms, Ti atoms and C atoms. As examples of such anionic groups there may be mentioned hydroxyl, nitrate, sulfate, carbonyl, carboxyl, carbonate and phenoxy.

As examples of onium salts there may be mentioned ammonium salts such as ammonium hydroxide, ammonium fluoride, ammonium chloride, ammonium bromide, ammonium iodide, ammonium phosphate, ammonium nitrate, ammonium borate, ammonium sulfate, ammonium formate, ammonium malate, ammonium fumarate, ammonium phthalate, ammonium malonate, ammonium succinate, ammonium tartrate, ammonium malate, ammonium lactate, ammonium citrate, ammonium acetate, ammonium propionate, ammonium butanoate, ammonium pentanoate, ammonium hexanoate, ammonium heptanoate, ammonium octanoate, ammonium nonanoate, ammonium decanoate, ammonium oxalate, ammonium adipate, ammonium sebacate, ammonium butyrate, ammonium oleate, ammonium stearate, ammonium linolate, ammonium linoleate, ammonium salicylate, ammonium benzenesulfonate, ammonium benzoate, ammonium p-aminobenzoate, ammonium p-toluenesulfonate, ammonium methanesulfonate, ammonium trifluoromethanesulfonate and ammonium trifluoroethanesulfonate.

There may also be mentioned the aforementioned ammonium salts wherein the ammonium ion is replaced with methylammonium ion, dimethylammonium ion, trimethylammonium ion, tetramethylammonium ion, ethylammonium ion, diethylammonium ion, triethylammonium ion, tetraethylammonium ion, propylammonium ion, dipropylammonium ion, tripropylammonium ion, tetrapropylammonium ion, butylammonium ion, dibutylammonium ion, tributylammonium ion, tetrabutylammonium ion, ethanolammonium ion, diethanolammonium ion, triethanolammonium ion or the like.

As examples of onium salts in addition to the aforementioned ammonium salts there may be used phosphonium salts, arsonium salts, stibonium salts, oxonium salts, sulfonium salts, selenonium salts, stannonium salts, iodonium salts and the like.

Preferred quaternary ammonium salts, from the viewpoint of promoting curing for the cured composition, include ammonium salts such as tetramethylammonium nitrate, tetramethylammonium acetate, tetramethylammonium propionate, tetramethylammonium malate and tetramethylammonium sulfate.

These may be used alone or in combinations of two or more.

The condensation accelerator catalyst may, if necessary, be dissolved in or diluted with water or a solvent before addition to a thermosetting composition or radiation-curing composition (hereinafter also referred to when necessary as "radiation-curing composition for forming a silica-based coating film"), for preparation to the desired concentration. There are no particular restrictions on the timing for addition of the condensation accelerator catalyst to the thermosetting composition or radiation-curing composition, but for example, it may be added when beginning the hydrolysis of component (a), during the hydrolysis, upon completion of the reaction, before or after distillation of the solvent, or at the point of addition of an acid generator.

The mixing proportion of the onium salt is preferably 0.001-5.0 wt% with respect to the total of the (a) siloxane resin, i.e. 0.001-5.0 parts by weight with respect to the total of the (a) siloxane resin, more preferably 0.001-4.0 wt%, i.e. 0.001-4.0 parts by weight, even more preferably 0.001-3.0 wt%, i.e. 0.001-3.0 parts by weight, yet more preferably 0.001-2.0 wt%, i.e. 0.001-2.0 parts by weight, and most preferably 0.01-2.0 wt%, i.e. 0.01-2.0 parts by weight. If the mixing proportion is less than 0.001 wt%, the electrical characteristics and mechanical strength of the finally obtained

silica-based coating film will tend to be inferior, while if it exceeds 5.0 wt%, the stability and film formability of the composition will tend to be inferior, and flatness, electrical characteristics and process adaptability of the silica-based coating film will tend to be poor.

From the standpoint of achieving significant improvement in the flatness of the silica-based coating film surface, the mixing proportion of the onium salt is preferably 0.001-0.5 wt% with respect to the total of the (a) siloxane resin, i.e. 0.001-0.5 part by weight with respect to 100 parts by weight as the total of the (a) siloxane resin, more preferably 0.001-0.4 wt% with respect to the total of the (a) siloxane resin, i.e. 0.001-0.4 part by weight with respect to 100 parts by weight as the total of the (a) siloxane resin, even more preferably 0.001-0.3 wt% with respect to the total of the (a) siloxane resin, i.e. 0.001-0.3 part by weight with respect to 100 parts by weight as the total of the (a) siloxane resin, yet more preferably 0.001-0.2 wt% with respect to the total of the (a) siloxane resin, i.e. 0.001-0.2 part by weight with respect to 100 parts by weight as the total of the (a) siloxane resin, very preferably 0.001-0.1 wt% with respect to the total of the (a) siloxane resin, i.e. 0.001-0.1 part by weight with respect to 100 parts by weight as the total of the (a) siloxane resin, and most preferably 0.01-0.1 wt% with respect to the total of the (a) siloxane resin, i.e. 0.01-0.1 part by weight with respect to 100 parts by weight as the total of the (a) siloxane resin.

These components (c) may, if necessary, be added after dissolution in or dilution with water or a solvent to the desired concentration.

When the onium salt is used as an aqueous solution, the pH is preferably 1.5-10, more preferably 2-8 and most preferably 3-6. The stability and film formability of the composition will tend to be inferior outside of this pH range.

The details of the mechanism by which the effect described above is exhibited by adding the onium salt are incompletely understood, but it is conjectured that the onium salt promotes the post-application dehydrating condensation reaction thereby increasing the siloxane bond density, and since the number of remaining silanol groups is lower, the film shrinkage ratio is reduced while the mechanical strength and dielectric characteristic are enhanced. The action is not limited to this conjecture, however.

The in-plane uniformity of the coating film thickness is evaluated by measuring the film thickness at a total of 9 points (shown as "×" in Fig. 1) which were at the center and at positions ±2 cm and ±4 cm from the center on the X-axis and Y-axis, of a 5-inch silicon wafer with the orientation flat or notch facing forward. The in-plane uniformity of the film thickness is determined from the following formula (D).

$$\text{In-plane uniformity (\%)} = (\text{maximum film thickness} - \text{minimum film thickness})/\text{average value of film thickness} \times 100 \qquad (D)$$

The in-plane uniformity is preferably no greater than 5%, more preferably no greater than 3%, even more preferably no greater than 2% and most preferably no greater than 1%.

A large in-plane uniformity of the coating film is not preferred because it will tend to lower the focus margin and result in poor resolution, for patterning of the resist on the upper layer. In the case of flat panel displays (FPD), the Al wiring width is at least 1 μm, but since the difference in film thickness within the plane is associated with color irregularities, a stricter degree of flatness and film thickness uniformity is sought than with semiconductors.

<Other components>

So long as the object and effect of the invention are not impeded, there may also be added pigments, surfactants, silane coupling agents, thickeners, inorganic fillers, thermal decomposing compounds such as polypropylene glycol, volatile compounds, and the like. Such thermal decomposing compounds and volatile compounds preferably decompose or volatilize by heat (preferably 200-500°C) to form voids. A void-forming function may also be imparted to the siloxane resin used as component (a). Voids can also be formed by addition of hollow particles or nanoclusters. A photoacid generator or photobase generator may also be added so that the composition for forming a silica-based coating film is a radiation-curing composition. The other components are preferably ones that do not interfere with the inhibition of the film shrinkage ratio according to the invention.

As the aforementioned thermal decomposing compounds and volatile compounds there are preferably further included void-forming compounds that undergo thermal decomposition or volatilization at a heating temperature of 200-500°C (hereinafter referred to as "component (d)"). Component (d) has the function of gradually forming fine pores (voids or holes) in the silica-based coating film, for further micronization and shape uniformity of the holes during the final curing. In order to exhibit this function, component (d) preferably has a percentage reduction of at least 95 wt%, more preferably at least 97 wt% and most preferably at least 99 wt% in a nitrogen gas atmosphere at a temperature of 200-500°C. If the percentage reduction is less than 95 wt%, dissolution or volatilization of the compound will tend to be insufficient when heating the composition for forming a silica-based coating film of the invention. Specifically, component

(d), a portion of component (d) or the reaction product from component (d) may remain in the finally obtained silica-based coating film. This may lead to impairment of the electrical characteristics of the silica-based coating film, including increase in the relative permittivity.

The "percentage reduction" of component (d) according to the invention is the value determined with the following apparatus under the following conditions. Specifically, the "percentage reduction" is measured for 10 mg of component (d), using a differential scanning calorimeter (TG/DTA6300 by Seiko Instruments, Inc.) under conditions with an initial temperature of 50°C before temperature elevation, a temperature-elevating rate of 10°C/min and a nitrogen ($N_2$) gas flow rate of 200 ml/min. As a reference there was used $\alpha$-alumina (product of Seiko Instruments, Inc.), with a 5 mm-diameter aluminum open sample pan (product of Seiko Instruments, Inc.) as the sample container.

The amount of substrate at the start of decomposition of component (d) is the mass at 150°C during temperature elevation. This is because the reduction in mass at below 150°C is due to removal of adsorbed water, while decomposition of component (d) itself essentially has not yet taken place. When component (d) cannot be directly measured out because of dissolution of component (d) in the solution or for other reasons, measurement of the "percentage reduction" is carried out by taking approximately 2 g of the solution containing component (d) into, for example, a metal dish, and drying it at 150°C for 3 hours in air at ordinary pressure to obtain a residue for use as the sample.

The thermal decomposing compound or volatile compound is not particularly restricted so long as it is thermally decomposing or volatile, and for example, there may be mentioned polymers with a polyalkylene oxide structure, (meth) acrylate-based copolymers, polyester copolymers, polycarbonate copolymers, polyanhydride copolymers, tetrakissilanes and the like. From the viewpoint of minimizing the film shrinkage ratio, the amount of hydroxyl (-OH) groups that interact with the siloxane resin in the thermal decomposing compound or volatile compound is preferably low.

A thermal decomposing compound or volatile compound containing hydroxyl (-OH) groups will solvate the siloxane resin obtained by hydrolysis of the compound of general formula (1), thus making it necessary to remove the compound for condensation of the siloxane resin, and interfering with curing at low temperature. The film shrinkage ratio during curing will also tend to be increased. However, in the absence of polar substituents such as hydroxyl (-OH) groups, compatibility with the siloxane polymer will be poor and film-forming defects and void sizes will tend to be increased. In order to reduce the film shrinkage ratio from the applied film to the silica-based coating film, therefore, the molecules of the void-forming compound preferably contain few hydroxyl groups.

If the thermal decomposing compound or volatile compound is thermally decomposing or volatile at a temperature below 200°C, thermal decomposition and volatilization will occur before formation of the siloxane skeleton, potentially preventing the desired dielectric characteristic from being achieved. On the other hand, if it is thermally decomposing or volatile at a temperature above 500°C, the wiring metal will tend to undergo deterioration. Thermal decomposition or volatilization with the temperature range specified above, therefore, has the advantage of inhibiting wiring metal deterioration and facilitating adjustment of the dielectric characteristic of the insulating film.

As examples of polyalkylene oxide structures there may be mentioned polyethylene oxide structures, polypropylene oxide structures, polytetramethylene oxide structures and polybutylene oxide structures. As polymers with polyalkylene oxide structures there may be mentioned, specifically, ether-type compounds such as polyoxyethylenealkyl ether, polyoxyethylenesterol ether, polyoxyethylenelanolin derivatives, ethylene oxide derivatives of alkylphenolformalin condensation products, polyoxyethylenepolyoxypropylene block copolymers and polyoxyethylenepolyoxypropylenealkyl ether, ether ester-type compounds such as polyoxyethyleneglycerin fatty acid esters, polyoxyethylenesorbitol fatty acid esters and polyoxyethylene fatty acid alkanolamide sulfates, and ether ester-type compounds such as polyethyleneglycol fatty acid esters, ethylene glycol fatty acid esters, fatty acid monoglycerides, polyglycerin fatty acid esters, sorbitan fatty acid esters and propyleneglycol fatty acid esters.

As examples of acrylic acid esters and methacrylic acid esters composing (meth)acrylate-based copolymers there may be mentioned alkyl acrylate esters, alkyl methacrylate esters, alkoxyalkyl acrylate esters, alkyl methacrylate esters and alkoxyalkyl methacrylate esters optionally having hydroxyl groups.

As examples of alkyl acrylate esters there may be mentioned C1-6 alkyl esters such as methyl acrylate, ethyl acrylate, n-propyl acrylate, isopropyl acrylate, n-butyl acrylate, isobutyl acrylate, pentyl acrylate and hexyl acrylate, as examples of alkyl methacrylate esters there may be mentioned C1-6 alkyl esters such as methyl methacrylate, ethyl methacrylate, n-propyl methacrylate, isopropyl methacrylate, n-butyl methacrylate, isobutyl methacrylate, pentyl methacrylate and hexyl methacrylate, as examples of alkoxyalkyl acrylate esters there may be mentioned methoxymethyl acrylate and ethoxyethyl acrylate, and as examples of alkoxyalkyl methacrylate esters there may be mentioned methoxymethyl methacrylate and ethoxyethyl methacrylate.

As examples of acrylic acid esters and methacrylic acid esters with hydroxyl groups there may be mentioned 2-hydroxylethyl acrylate, 2-hydroxylpropyl acrylate, 2-hydroxylethyl methacrylate and 2-hydroxylpropyl methacrylate.

As examples of polyester polymers there may be mentioned hydroxycarboxylic acid polycondensation products, lactone ring-opening polymerization products, and aliphatic polyol and aliphatic polycarboxylic acid polycondensation products.

As examples of polycarbonate polymers there may be mentioned polycondensation products of carbonic acid

and alkylene glycols, such as polyethylene carbonate, polypropylene carbonate, polytrimethylene carbonate, polytetramethylene carbonate, polypentamethylene carbonate and polyhexamethylene carbonate.

As examples of polyanhydride polymers there may be mentioned dicarboxylic acid polycondensation products such as polymalonyl oxide, polyadipoyl oxide, polypimeloyl oxide, polysuberoyl oxide, polyazelayl oxide and polysebacoyl oxide.

As examples of tetrakissilanes there may be mentioned tetrakis(trimethylsiloxy)silane, tetrakis(trimethylsilyl) silane, tetrakis(methoxyethoxy)silane, tetrakis(methoxyethoxyethoxy)silane and tetrakis(methoxypropoxy)silane.

These may be used alone or in combinations of two or more.

From the viewpoint of solubility in the solvent, compatibility with the siloxane resin, mechanical properties of the film and moldability of the film, the Mw of component (d) is preferably 200-10,000, more preferably 300-5000 and even more preferably 400-2000. If the Mw exceeds 100,000, compatibility with the siloxane resin will tend to be lower. On the other hand, if it is less than 200, the formation of voids will tend to be inadequate.

There are no particular restrictions on the aforementioned photoacid generator or photobase generator (hereinafter referred to as "component (e)", but the following may be mentioned.

The type of acid generators listed below are not intended to be restrictive. As compounds for component (e) there may be used, specifically, diarylsulfonium salts, triarylsulfonium salts, dialkylphenacylsulfonium salts, diaryliodonium salts, aryldiazonium salts, aromatic tetracarboxylic acid esters, aromatic sulfonic acid esters, nitrobenzyl esters, oximesulfone acid esters, aromatic N-oxyimide sulfonates, aromatic sulfamides, haloalkyl group-containing hydrocarbon compounds, haloalkyl group-containing heterocyclic compounds, naphthoquinonediazide-4-sulfonic acid esters, and the like. Such compounds may be used in combinations of two or more if necessary, and they may also be combined with other sensitizing agents.

The type of base generators listed below are not intended to be restrictive. Typical examples of compounds for component (e) include nonionic compounds such as the group of compounds represented by general formulas (2)-(5) below, or nifedipines, and ionic compounds such as cobalt amine complexes and the quaternary ammonium salts represented by general formulas (6) and (7) below, although there is no restriction to these.

$$(R^2\text{-OCO-NH})_m\text{-}R^3 \qquad (2)$$

(wherein $R^2$ represents a C1-30 monovalent organic group, which optionally contains an aromatic ring substituted with a methoxy or nitro group, $R^3$ represents a C1-20 mono- to tetravalent organic group, and m represents an integer of 1-4).

$$(R^4R^5C\text{=N-OCO})_m\text{-}R^3 \qquad (3)$$

(wherein $R^3$ has the same definition as in general formula (2), $R^4$ and $R^5$ each independently represent a C1-30 monovalent organic group, optionally bonding together to form a ring structure, and m represents an integer of 1-4).

$$R^2\text{-OCO-NR}^6R^7 \qquad (4)$$

(wherein $R^2$ has the same definition as in general formula (2), $R^6$ and $R^7$ each independently represent a C1-30 monovalent organic group, optionally bonding together to form a ring structure, and one of $R^6$ and $R^7$ may be a hydrogen atom).

$$R^8\text{-CO-}R^9\text{-NR}^6R^7 \qquad (5)$$

(wherein $R^6$ and $R^7$ have the same definition as in general formula (4), $R^8$ represents a C1-30 monovalent organic group, optionally including an aromatic ring substituted with an alkoxy, nitro, amino, alkylsubstituted amino or alkylthio group, and $R^9$ represents a C1-30 divalent organic group).

[Chemical Formula 1]

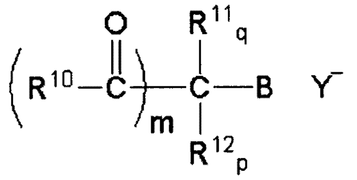

B = 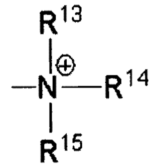 , 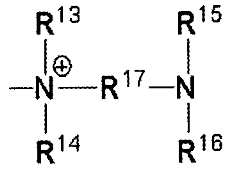 , 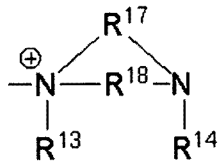 , · · · (6)

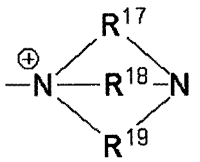 , 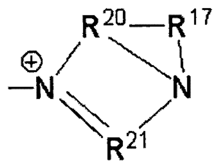 or 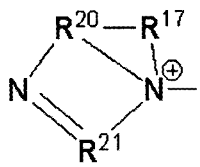

(wherein $R^{10}$ represents a C1-30 monovalent organic group, $R^{11}$ and $R^{12}$ represent hydrogen or C1-30 monovalent organic groups, $R^{13}$, $R^{14}$, $R^{15}$ and $R^{16}$ each independently represent a C1-30 monovalent organic group, $R^{17}$, $R^{18}$ and $R^{19}$ each independently represent a C0-30 divalent organic group, $R^{20}$ and $R^{21}$ each independently represent a C1-30 trivalent organic group, Y represents the counter ion of the ammonium salt, m represents an integer of 1-3 and q and p are each 0, 1 or 2, with the proviso that m+q+p = 3).

[Chemical Formula 2]

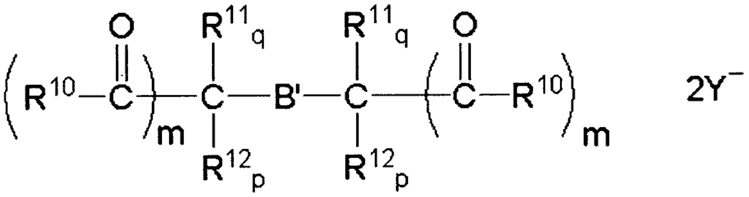

B' = 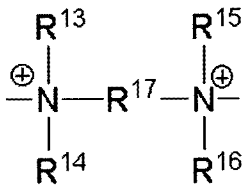 , 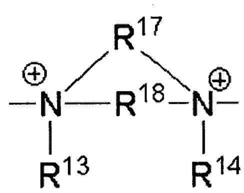 , · · · (7)

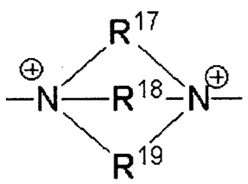 or 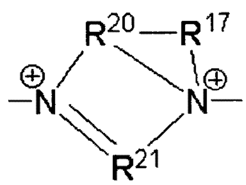

(wherein $R^{10}$-$R^{21}$, Y, m, q and p have the same definition as in general formula (6).

The amount of addition of component (e) is not particularly restricted and may be within a wide range depending on the sensitivity and efficiency of the acid generator or base generator used, the light source used and the desired cured film thickness. Specifically, it is preferably 0.0001-50 wt%, more preferably 0.001-20 wt% and even more preferably 0.01-10 wt% with respect to the resin component in the radiation-curing composition used as the composition for forming a silica-based coating film. If the amount of use is less than 0.0001 wt%, the photocuring property will tend to be reduced, or a high level of light exposure may be necessary for curing. On the other hand, if the amount of use exceeds 50 wt%, the stability and film formability of the composition will tend to be inferior, and the electrical characteristics and process adaptability of the cured composition will tend to be poor.

A photosensitizer may also be used in the radiation-curing composition. Using a photosensitizer will allow efficient absorption of radiation energy rays and can improve the sensitivity of the photobase generator. As photosensitizers there may be mentioned anthracene derivatives, perylene derivatives, anthraquinone derivatives, thioxanthone derivatives, coumarin and the like.

A pigment may also be added to the radiation-curing composition. Addition of a pigment provides an effect of adjusting the sensitivity and inhibiting the standing wave effect.

So long as the object and effect of the invention are not impeded, there may also be added surfactants, silane coupling agents, thickeners, inorganic fillers and the like.

The contents of each of the components of the composition for forming a silica-based coating film of the invention will now be explained. The content of component (a) in the composition for forming a silica-based coating film of the invention is preferably 3-25 wt%. If the concentration of component (a) exceeds 25 wt%, the amount of organic solvent will tend to be too low, resulting in poor film formability of the silica-based coating film and reduced stability of the composition itself. On the other hand, if the concentration of component (a) is below 3 wt%, the amount of solvent will tend to be too high, resulting in more difficult formation of a silica-based coating film with the desired film thickness.

The content of component (b) is the remainder after subtracting the total weights of component (a), component (c), component (d), component (e) and other components added as necessary from the weight of the composition.

The composition for forming a silica-based coating film of the invention preferably contains no alkali metals or alkaline earth metals. Even if such metals are present, their metal ion concentrations in the composition are preferably no greater than 100 ppb and more preferably no greater than 20 ppb. If the metal ion concentration exceeds 100 ppb, the metal ions will more readily enter into the semiconductor element with the silica-based coating film obtained from the composition, thus potentially having an adverse effect on the device performance. It is therefore effective to use an ion-exchange filter as necessary to remove alkali metals and alkaline earth metals from the composition.

A method of forming a silica-based coating film on a substrate using a composition for forming a silica-based coating film according to the invention as described above will now be explained, using as an example spin coating method which generally provides excellent film formability and film uniformity. The silica-based coating film-forming process, however, is not limited to spin coating method. The substrate may have a flat surface or it may have raised and indented sections from formation of electrodes and the like, since the composition for forming a silica-based coating film of the invention adequately exhibits its properties with substrates having raised and indented sections on the surface from formation of electrodes and the like. The material used for the substrate may be, in addition to any of the materials mentioned above, an organic polymer such as polyethylene terephthalate, polyethylene naphthalate, polyamide, polycarbonate, polyacryl, nylon, polyethersulfone, polyvinyl chloride, polypropylene or triacetylcellulose. A plastic film composed of the aforementioned organic polymer may also be used.

(Silica-based coating film forming method, silica-based coating film, and electronic part)

Preferred embodiments of the silica-based coating film forming method, silica-based coating film and electronic part according to the invention will now be explained with reference to the accompanying drawings.

A composition for forming a silica-based coating film of the invention may be used to form a silica-based coating film according to the invention by spin coating method in the following manner, for example. Spin coating method provides excellent coating film formability and uniformity, and is therefore suitable for formation of a silica-based coating film of the invention. The coating method is not limited to spin coating method, and for example, spray coating method may be used as an alternative coating method.

First, the composition for forming a silica-based coating film is spin coated onto a substrate such as a silicon wafer at preferably 500-5000 rpm and more preferably 700-3000 rpm to form an applied film (coated film). If the rotation speed is less than 500 rpm, the film uniformity will tend to be poor. On the other hand, if it is greater than 5000 rpm, the film formability may be impaired.

The film thickness of the coated film will differ depending on the purpose of use, and for example, a coated film wherein the cured film (cured coating film) is to be used as an interlayer insulating film for an LSI or the like preferably has a film thickness which will give a cured film (coating film) thickness of 0.010-2.0 μm, whereas a coated film wherein

the cured film (coating film) is to be used as a passivation layer preferably has a film thickness which will give a cured film (coating film) thickness of 2.0-40 μm. A coated film wherein the cured film (coating film) is to be used for a liquid crystal preferably has a film thickness which will give a cured film (coating film) thickness of 0.10-20 μm, a coated film for use in a photoresist preferably has a film thickness which will give a cured film (coating film) thickness of 0.10-2.0 μm, and a coated film for use as a optical waveguide preferably has a film thickness which will give 1.0-50 μm. For most cases, the film thickness of the cured film (coating film) is preferably 0.010-10 μm, more preferably 0.010-5.0 μm, even more preferably 0.010-3.0 μm, especially preferably 0.010-2.0 μm and most preferably 0.10-2.0 μm. The film thickness of the cured film (coating film) may be regulated, for example, by adjusting the mixing proportion of component (a) in the composition. When using a spin coating method, the film thickness can be regulated by adjusting the rotation rate and the frequency of application. When the film thickness is controlled by adjusting the mixing proportion of component (a), for example, the film thickness can be increased by raising the concentration of component (a), or the film thickness can be decreased by lowering the concentration of component (a). When a spin coating method is used to regulate the film thickness, for example, the film thickness can be increased by lowering the rotation rate or increasing the frequency of application, while the film thickness can be decreased by raising the rotation rate or decreasing the frequency of application.

The organic solvent in the applied film is then dried off by volatilization with a hot plate, preferably at 50-350°C, more preferably at 100-300°C and most preferably at 100-250°C. A drying temperature of below 50°C will tend to result in insufficient drying of the organic solvent. With a drying temperature of above 350°C, on the other hand, component (d) used for porous (void) formation may undergo thermal decomposition and volatilization to an undesirable degree before the siloxane skeleton of the siloxane resin has been sufficiently formed, potentially making it difficult to obtain a silica-based coating film with the desired mechanical strength and low dielectric characteristic.

The applied film from which the organic solvent has been removed is then subjected to final curing by firing at a heating temperature of 250-500°C, preferably 300-500°C and more preferably a higher temperature than the temperature for removal of the organic solvent. This forms a silica-based coating film that can exhibit a low relative permittivity (low-k film) even in a high frequency range of 100 kHz and greater. The term "relative permittivity" according to the invention means the value measured in an atmosphere of 23°C ±2°C, 40% ±10% RH, and it is a value of preferably no greater than 4.0, more preferably no greater than 3.5, even more preferably no greater than 3.0, yet more preferably no greater than 2.6, even yet more preferably no greater than 2.5 and most preferably 2.2. The lower limit will normally be about 1.5. It is preferably not below 1.5 because the mechanical strength may be reduced as a result. For lowering of the relative permittivity it is effective, for example, to increase the number of fine pores introduced. However, if too many fine pores are introduced, the mechanical strength of the silica-based coating film may be reduced. The relative permittivity may be determined, for example, by measuring the charge capacity between Al metal and an N-type low resistivity substrate (Si wafer).

More specifically, the relative permittivity may be determined in the following manner. First, a coating film is formed to a coating film thickness of 0.5-0.6 μm. Specifically, after application onto a low resistivity silicon wafer (resistivity < 10 Ωcm) by spin coating method, the solvent is removed with a hot plate heated to 200°C and final curing is performed at 400°C/30 min in a nitrogen atmosphere to form a coating film. After formation of the coating film, Al metal is vapor deposited to a diameter of 2 mm and a thickness of about 0.1 μm using a vapor deposition apparatus. The insulating coating film has a structure sandwiched between the Al metal and the low resistivity silicon wafer, and the charge capacity thereof is measured. The film thickness referred to here is the film thickness measured with an L116B ellipsometer by Gartner, Inc., and specifically, it is the film thickness determined from the phase contrast produced upon irradiation of the coating film with a He-Ne laser.

The relative permittivity of the coating film may be measured by measuring the charge capacity between the Al metal and the low resistivity silicon wafer. The charge capacity is measured by connecting a dielectric material test fixture (HP16451B, product of Yokogawa Electric Corp.) to an LF impedance analyzer (HP4192A, product of Yokogawa Electric Corp.). The value obtained with a measuring frequency of 1 MHz is used. The measured value is substituted into the following formula (E), and the relative permittivity of the coating film is determined.

$$\text{(Coating film relative permittivity)} = 3.597 \times 10^{-2} \times \text{(Charge capacity [units: pF])} \times \text{(coating film thickness [units: μm])} \quad \text{(E)}$$

The silica-based coating film of the invention has an elastic modulus of preferably 2.5 GPa or greater, more preferably 3.0 GPa or greater, even more preferably 3.5 GPa or greater, very preferably 4.0 GPa or greater and most preferably 4.5 GPa or greater. There is no particular restriction on the upper limit, but it will usually be about 30 GPa. The elastic modulus is preferably not less than 2.5 GPa because problems may arise during working when the film is

used, for example, as a semiconductor insulating film. An increased elastic modulus can be achieved, for example, by reducing the proportion of pores in the silica-based coating film.

According to the invention, the elastic modulus of the film is the elastic modulus in the region near the surface of the film and is the value obtained using a DCM nanoindenter by MTS. The method of forming the coating film may involve spin coating onto a silicon wafer to a coating film thickness of 0.5-0.6 μm, removing the solvent with a hot plate and then curing at 425°C/30 min. A small coating film thickness is not preferred because the underlying layer will become more prominent. The elastic modulus in the region near the surface of the film is that in the region at a depth of within 1/10 of the film thickness, and specifically a depth of 15-50 nm from the film surface.

The load and loading speed are varied in the relationship represented by the following formula (F).

$$dL/dt \times 1/L = 0.05 \text{ [units: sec}^{-1}\text{]} \qquad \text{(F)}$$

Here, L represents the load and t represents time. The indenter used for indenting is a Berkovich indenter (material: diamond), and the measurement is carried out with the amplitude frequency of the indenter set to 45 Hz.

The flattening percentage of the coating film of the invention is preferably 80%-100%, and more preferably 85%-100%. The "flattening percentage" is the value calculated in the following manner.

(1) First, an evaluation wafer is prepared. The evaluation wafer is obtained by first forming a $SiO_2$ film to a thickness of 700 nm on a silicon wafer. A resist is then formed thereover, and the resist is patterned through the mask with a line/space width of 800/800 nm. The $SiO_2$ film is then etched to a depth 700 nm. Next, after removing the resist, formation of the $SiO_2$ film is continued thereover to 100 nm (50 nm on both sides of the line). This yields a patterned wafer (evaluation wafer) with a height of 700 nm and a line/space width of 900/700 nm. The flattening percentage is evaluated using the center space with 6 lines in the evaluation wafer.

(2) Next, the composition for forming a silica-based coating film is dropped onto the center of the silicon wafer. It is then spin coated for 30 seconds at a rotation rate for a film thickness of 500 $\pm$10 nm after curing of the applied film on the silicon wafer, and heated to 250°C within 30 seconds and baked for 3 minutes at that temperature. It is then cured at 400°C for 30 minutes in a nitrogen atmosphere to obtain a cured coating film.

(3) The cross-section of the center space with six 900 nm lines (space width: 700 nm) was observed by SEM, the film thickness (D2) of the coating film 52 at the center of the recess and the top height (D1) of the line of the evaluation wafer 51 were measured, and the flattening percentage was calculated by the following formula (G) (see Fig. 6).

$$\text{Flattening percentage (\%)} = D2/D1 \times 100 \text{ (G)}$$

The silica-based coating film of the invention has sufficient mechanical strength and can be cured at low temperature and in a short period of time compared to the prior art. The final curing is preferably carried out in an inert atmosphere such as nitrogen, argon or helium, in which case the oxygen concentration is preferably no greater than 1000 ppm. If the heating temperature is below 250°C it may not be possible to achieve sufficient curing, while decomposition and volatilization of component (d) will tend to be inadequate. In contrast, if the heating temperature is higher than 500°C the thermal budget may be increased in the case of a metal wiring layer, potentially leading to deterioration of the wiring metal.

The heating time for the curing is preferably 2-60 minutes and more preferably 2-30 minutes. If the heating time is greater than 60 minutes, the thermal budget will be excessively increased, potentially leading to deterioration of the wiring metal. The heating apparatus used is preferably a quartz tube furnace or other type of furnace, a hot plate or a heat treatment apparatus for rapid thermal annealing (RTA).

The film thickness of the silica-based coating film formed in this manner is preferably 0.01-40 μm and more preferably 0.1 μm-2.0 μm. If the film thickness exceeds 40 μm, cracks will tend to form due to stress. On the other hand if the film thickness is less than 0.01 μm, and metal wiring layers are present in the upper and lower layers of the silica-based coating film, the interconnect leak characteristic of the upper and lower layers will tend to be impaired.

Fig. 5 is a partial end view flow chart showing an embodiment of a method for forming a silica-based coating film according to the invention. First, in step (a), the composition for forming a silica-based coating film of the invention is coated onto a substrate 300 and an electrode 350 formed on the substrate 300 by the above-mentioned spin coating method, or the like, to form a coated film 310. Since the coated film 310 is formed from the composition for forming a silica-based coating film of the invention, its surface does not contain very large indentations even when on the surfaces

of the recesses 330 between electrodes 350. Next, in step (b), a hot plate or the like is used for volatilization and drying of the organic solvent in the coated film 310. Here, the composition for forming a silica-based coating film of the invention has a low film shrinkage ratio, and therefore indentations 370 do not readily form in the surfaces of the recesses 330, or even if indentations 370 are formed they are of sufficiently small size. Because the coated film has a low film shrinkage ratio, shrinkage of the coated film is adequately prevented during the drying stage. In step (c), the coated film 310 is fired for final curing to obtain a silica-based coating film 320. The silica-based coating film 320 can fill the recesses 330 between electrodes 350 without leaving voids, and its surface flatness is sufficiently high. Moreover, since the film shrinkage ratio of the silica-based coating film 320 is below 27%, it is possible to satisfactorily prevent dropping and deformation of the electrodes 350, and peeling of the silica-based coating film 320 from the electrodes 350.

The silica-based coating film 320 formed on the electrodes 350 may, if necessary, be removed by polishing or the like.

There are no particular restrictions on the pattern of raised and indented sections on the substrate surface on which the silica-based coating film is coated, but preferred, for example, are patterns with protrusion heights (or recess depths; h in Fig. 5) of about 100-1000 nm (more preferably 250-500 nm) or patterns with recess widths (w in Fig. 5) of about 10-10,000 nm (more preferably 20-1000 nm), and more preferably the substrate has a plurality of such patterns.

As electronic parts according to the invention employing a silica-based coating film formed in the manner described above there may be mentioned electronic devices with silica-based coating films such as semiconductor elements or multilayer interconnection boards, and flat panel displays (FPD) with silica-based coating films. The silica-based coating film of the invention may be used as a surface protecting film (passivation film), buffer coat film, interlayer insulating film or the like for a semiconductor element. It may also be suitably used as an interlayer insulating film for a multilayer interconnection board. It may further be used as a transistor insulating film, interlayer insulating film, low refractive index film or protecting film for a flat panel display (FPD).

Specifically, as semiconductor elements there may be mentioned discrete semiconductor elements such as diodes, transistors, compound semiconductors, thermistors, varistors and thyristors, memory elements such as DRAM (Dynamic Random Access Memory), SRAM (Static Random Access Memory), EPROM (Erasable/Programmable Read-Only Memory), Mask ROM (Mask Read-Only Memory), EEPROM (Electrical Erasable/Programmable Read-Only Memory) and flash memory, logic circuit elements such as microprocessors, DSP and ASIC, integrated circuit elements including compound semiconductors such as MMICs (Monolithic Microwave Integrated Circuit), hybrid integrated circuits (Hybrid IC), and photoelectric conversion elements such as light emitting diodes and charge-coupled elements. As multilayer interconnection boards there may be mentioned high density wiring boards such as MCMs. As flat panel displays (FPD) there may be mentioned transistors for liquid crystals, organic ELs, plasma displays and the like. In addition to these uses there may be mentioned coating films for optical waveguides, resists, solar panels and the like.

A radiation-curing composition which is a composition for forming a silica-based coating film containing an added photoacid generator or photobase generator is heated with a hot plate or the like at preferably 50-200°C and more preferably 70-150°C to evaporate off the organic solvent and water in the coated film for drying of the coated film. A drying temperature of below 50°C will tend to result in insufficient volatilization of the organic solvent. On the other hand, a drying temperature of above 200°C will impede dissolution of the coated film in the developing solution during the subsequent developing treatment, and tend to reduce the pattern precision.

The coated film is then exposed to radiation through a mask having the desired pattern. This forms a cured film (coating film) by curing of the exposed sections of the coated film exposed to the radiation. The exposure dose is preferably 5.0-5000 $mJ/cm^2$, more preferably 5.0-1000 $mJ/cm^2$, even more preferably 5.0-500 $mJ/cm^2$ and most preferably 5.0-100 $mJ/cm^2$. An exposure dose of less than 5.0 $mJ/cm^2$ may make control difficult depending on the light source, while an exposure dose of greater than 5000 $mJ/cm^2$ will lengthen the exposure time and may lower productivity. The exposure dose for ordinary conventional siloxane-based radiation-curing compositions is about 500-5000 $mJ/cm^2$.

The term "radiation" according to the invention refers to electromagnetic waves or an electron beam, and as examples there may be mentioned visible light rays, ultraviolet rays, infrared rays, X-rays, $\alpha$-rays, $\beta$-rays, $\gamma$-rays and the like. Ultraviolet rays are particularly preferred among these. The source for the ultraviolet rays may be, for example, an ultra-high pressure mercury lamp, high-pressure mercury lamp, low-pressure mercury lamp, metal halide lamp, excimer lamp or the like.

The exposure may be followed by a heating step (post exposure baking: PEB) if necessary. The heat treatment in this step involves using heating means such as a hot plate to heat at least the exposed sections that have been cured by exposure (the cured film or coating film). The heating is preferably in a temperature range that does not lower the solubility of the coated film on the unexposed sections in the developing solution. The heating temperature is preferably 50-200°C, more preferably 70-150°C, even more preferably 70-110°C and most preferably 70-100°C. A higher temperature will tend to generally promote diffusion of the generated acid, and therefore a lower heating temperature is preferred. The heating temperature in the PEB step for ordinary conventional siloxane-based radiation-curing compositions is about 115-120°C.

From the viewpoint of inhibiting diffusion of the acid and minimizing production cost, preferably no such heating

step is carried out after exposure and before development.

The unexposed sections of the radiation-curing composition coated film are then removed, development is carried out. The unexposed sections that were blocked from radiation exposure by the mask in the exposure step are sufficiently soluble in the developing solution used for development. However, the exposed sections irradiated with the radiation generate acidic active substances or basic active substances by the exposure, thus undergoing hydrolytic condensation reaction and lowering their solubility in the developing solution. This selectively leaves only the exposed sections (cured film or coating film) on the substrate, forming a pattern.

A developing solution such as an aqueous alkali solution may be used for the development. As examples of aqueous alkali solutions there may be mentioned aqueous solutions of inorganic alkalis such as sodium hydroxide, potassium hydroxide, sodium carbonate, sodium silicate, sodium metasilicate and ammonia; primary amines such as ethylamine and n-propylamine; secondary amines such as diethylamine and di-n-propylamine; tertiary amines such as triethylamine and methyldiethylamine; alcohol amines such as dimethylethanolamine and triethanolamine; and quaternary ammonium salts such as tetramethylammonium hydroxide (TMAH) and tetraethylammonium hydroxide. There may also be used aqueous solutions containing suitable amounts of water-soluble organic solvents or surfactants added to these aqueous alkali solutions. When a radioactive cured composition is used for production of an electronic part, the electronic part must not be contaminated by alkali metals, and therefore a tetramethylammonium hydroxide aqueous solution is preferred as the developing solution.

The preferred developing time will depend on the film thickness of the coated film or cured film (coating film) and the solvent, but it is preferably from 5 seconds to 5 minutes, more preferably from 30 seconds to 3 minutes and most preferably from 30 seconds to 1 minute. If the developing time is less than 5 seconds it will often be difficult to control the time across the entire surface of the wafer or substrate, while if it is greater than 5 minutes the productivity will tend to be reduced. There are no particular restrictions on the treatment temperature for development, but it will generally be 20-30°C. The developing method may employ a system using, for example, spraying, paddling, dipping, ultrasonic waves or the like.

The pattern formed by the development may be rinsed with distilled water or the like if necessary.

The cured film (coating film) obtained from the radiation-curing composition and patterned in this manner may be used directly as a resist mask.

When the cured film (coating film) that has been patterned in the manner described above is left on a substrate or in an electronic part as an interlayer insulating film, clad layer or the like, the cured film (coating film) is preferably fired at a heating temperature of 100-500°C, for example, for final curing. The final curing is preferably carried out in an inert atmosphere such as $N_2$, Ar or He, in air or under reduced pressure conditions, but there are no particular restrictions on the surrounding atmosphere or pressure so long as the properties required for the intended purpose are satisfied. The heating temperature for the final curing is 100°C-500°C, preferably 150-500°C and more preferably 200-500°C in order to further improve the curability of the exposed sections and increase the electrical insulating property. A lower heating temperature is preferred to minimize deterioration of the material used in the layer under the coated film, such as the substrate or wafer. It is also preferably a higher temperature than the heating temperature during removal of the organic solvent and/or the heating temperature for the PEB step.

The heating time for the final curing is preferably 2-240 minutes and more preferably 2-120 minutes. A heating time of longer than 240 minutes may not be suitable for mass production. The heating apparatus may be, for example, a furnace such as a quartz tube furnace, a hot plate, or a heat treatment apparatus such as a rapid thermal annealing (RTA) furnace.

As examples of electronic parts with such a cured film (coating film or cured composition) there may be mentioned devices with insulating films such as semiconductor elements and multilayer interconnection boards. Specifically, the cured film (coating film) may be used as a surface protecting film (passivation film), buffer coat film, interlayer insulating film or the like for a semiconductor element. The cured film (coating film) may also be suitably used as an interlayer insulating film for a multilayer interconnection board.

As examples of semiconductor elements there may be mentioned discrete semiconductor elements such as diodes, transistors, compound semiconductors, thermistors, varistors and thyristors, memory elements such as DRAM (Dynamic Random Access Memory), SRAM (Static Random Access Memory), EPROM (Erasable/Programmable Read-Only Memory), Mask ROM (Mask Read-Only Memory), EEPROM (Electrical Erasable/Programmable Read-Only Memory) and flash memory, logic circuit elements such as microprocessors, DSP and ASIC, integrated circuit elements including compound semiconductors such as MMICs (Monolithic Microwave Integrated Circuit), hybrid integrated circuits (Hybrid IC), and photoelectric conversion elements such as light emitting diodes and charge-coupled elements. As examples of multilayer interconnection boards there may be mentioned high density wiring boards such as MCMs.

Other uses include, but are not limited to, display parts such as liquid crystals, organic transistors, optical waveguides, photoresists and the like. For use in a display such as a liquid crystal part or the like, the refractive index of the silica-based coating film is preferably no greater than 1.42, more preferably no greater than 1.35 and even more preferably no greater than 1.30.

Fig. 2 is a schematic end view showing an embodiment of a TFT (thin-film transistor) according to the invention, as an electronic part to be used in a TFT liquid crystal display. In this TFT, a conductive layer 3 made of polysilicon is formed on an undercoat film 2 formed on a glass substrate 1, and a source 4 and drain 5 are situated sandwiching the conductive layer 3 within the plane. A gate electrode 7 is also formed on the conductive layer 3 via a gate oxide film 6 with $SiO_2$ as the structural material. The gate oxide film 6 is formed so that the conductive layer 3 does not directly contact with the gate electrode 7. The undercoat film 2, as well as the conductive layer 3, source 4, drain 5, gate oxide film 6 and gate electrode 7, are covered by a first interlayer insulating film 8 to prevent shorting. A portion of the first interlayer insulating film 8 is removed during formation of the TFT, and metal wirings 9 extend out in connection with the source 4 and drain 5, respectively. Of the metal wirings 9, the metal wiring 9 extending out in connection with the drain 5 is electrically connected with the transparent electrode 11, while its other portion is covered by the second interlayer insulating film 10 to avoid shorting.

The cured film (silica-based coating film), obtained from the thermosetting composition or radiation-curing composition as the composition for forming a silica-based coating film of the invention, will usually be used as the second interlayer insulating film 10 in the TFT, but it may also be used as the first interlayer insulating film 8. The interlayer insulating films 8, 10 are formed in the following manner, for example. First, the radiation-curing composition is applied onto the substrate by spin coating or the like and dried to obtain a coated film. Next, specific sections of the coated film are cured by exposure through a mask with a prescribed pattern (in the case of the first interlayer insulating film 8, these are the sections other than those on which the metal wiring 9 is to be formed, and in the case of the second interlayer insulating film 10, they are the sections other than those on which the transparent electrode 11 are to be formed), and further heat treatment is carried out if necessary. The unexposed sections are removed by developing treatment to obtain interlayer insulating films 8, 10. This is followed by final curing by heat treatment if necessary. The interlayer insulating films 8, 10 may have the same composition or different compositions.

An electronic part such as illustrated above has adequately reduced relative permittivity of the silica-based coating film compared to the prior art, and therefore the wiring delay time for signal propagation can be satisfactorily shortened while high reliability can also be achieved. It is also possible to achieve improved production yield and process tolerance for electronic parts. The aforementioned excellent characteristics of a silica-based coating film composed of a composition for forming a silica-based coating film according to the invention make it possible to provide electronic parts with high density, high quality and superior reliability.

According to the preferred embodiments of the invention described above, it is possible to provide a coating film, silica-based coating film, composition for forming a silica-based coating film and a method for forming it and electronic parts comprising the silica-based coating film, which realize excellent surface flatness, excellent in-plane uniformity of the film thickness while minimizing film irregularities such as striation, superior low dielectricity, sufficient mechanical strength, suitability for curing at low temperature and in a short period of time compared to the prior art, a low film shrinkage ratio during curing, and the ability to fill in recesses without leaving voids.

## Examples

Preferred examples of the invention will now be explained in detail, with the understanding that the invention is in no way limited to these examples. The radiation-curing composition is preferably handled in an environment free of the photosensitive wavelength of the acid generator and sensitizing agent used until completion of the step of developing the photoacid generator itself or the radiation-curing composition containing the photoacid generator, in_order to avoid excitation of the photoacid generator.

<Preparation of composition for forming a silica-based coating film>

(Example 1)

To a solution containing 17.3 g of tetraethoxysilane and 13.5 g of methyltriethoxysilane dissolved in 60.3 g of cyclohexanone, there was added 9.14 g of a 0.644% nitric acid aqueous solution dropwise over 2 minutes while stirring. Upon completion of the dropwise addition, reaction was conducted for 1.5 hours and then 0.438 g of a 2.38% tetramethylammonium nitrate aqueous solution (pH 3.6) was added, stirring was continued for 2 hours, and a portion of cyclohexanone and the produced ethanol in the warm bath was distilled off under reduced pressure to obtain 63.3 g of a polysiloxane solution. Next, 2.94 g of polypropylene glycol (PPG725, trade name of Aldrich Co.) as a void-forming compound and 33.8 g of cyclohexanone were added to the polysiloxane solution, and the mixture was stirred to dissolution at room temperature (25°C) for 30 minutes to prepare a composition for forming a silica-based coating film. The polypropylene glycol (PPG725, trade name of Aldrich Co.) used as the void-forming compound had a weight reduction of 99.9% at 350°C.

(Comparative Example 1)

To a solution containing 17.3 g of tetraethoxysilane and 13.5 g of methyltriethoxysilane dissolved in 60.7 g of cyclohexanone, there was added 9.13 g of a 0.644% nitric acid aqueous solution dropwise over 4 minutes while stirring. Upon completion of the dropwise addition, reaction was conducted for 4 hours, and a portion of cyclohexanone and the produced ethanol in the warm bath was distilled off under reduced pressure to obtain 62.3 g of a polysiloxane solution. Next, 2.94 g of polypropylene glycol (PPG725, trade name of Aldrich Co.) as a void-forming compound and 34.8 g of cyclohexanone were added to the polysiloxane solution, and the mixture was stirred to dissolution at room temperature for 30 minutes to prepare a composition for forming a silica-based coating film. The polypropylene glycol (PPG725, trade name of Aldrich Co.) used as the void-forming compound had a weight reduction of 99.9% at 350°C.

<Fabrication of interlayer insulating film>

The composition for forming a silica-based coating films obtained in Example 1 and Comparative Example 1 were sampled in a 2 mL plastic syringe, a filter with a PTFE 0.20 μm pore size was attached to the tip thereof, and 1.5 mL of the composition for forming a silica-based coating film was dropped onto a 5-inch silicon wafer from the syringe and spin coating was performed to obtain a coated film. For formation of the applied film, the rotation rate was adjusted so that the coating film had a film thickness of 225 ±25 nm after curing. The organic solvent in the applied film was removed at 250°C over a period of 3 minutes. The applied film from which the organic solvent had been removed was subjected to final curing for 30 minutes at 400°C using a quartz tube furnace controlled to an $O_2$ concentration of about 100 ppm, to fabricate a silica-based coating film as an interlayer insulating film.

The obtained silica-based coating film was irradiated with He-Ne laser light, and the film thickness determined from the phase contrast produced by light irradiation at a wavelength of 633 nm was measured using a spectroscopic ellipsometer (L116B ellipsometer, trade name of Gartner, Inc.).

Next, a vapor deposition apparatus was used for vapor deposition of Al metal on the silica-based coating film in a circular form with a diameter of 2 mm, to a thickness of about 0.1 μm. This formed an interlayer insulating film having a structure with the silica-based coating film between the Al metal and the silicon wafer (low resistivity substrate).

[Measurement of relative permittivity]

The charge capacity of the interlayer insulating film consisting of the obtained coating film was measured using an apparatus comprising a dielectric material test fixture (HP16451B, product of Yokogawa Electric Corp.) connected to an LF impedance analyzer (HP4192A, product of Yokogawa Electric Corp.), under conditions with a temperature of 23°C ±2°C, a humidity of 40% ±10% and a use frequency of 1 MHz. The measured value of the charge capacity was substituted into formula (E) above to calculate the relative permittivity of the interlayer insulating film. The film thickness used for the interlayer insulating film was the value obtained by measurement of the film thickness of the silica-based coating film.

[Measurement of elastic modulus]

A nanoindenter SA2 (DCM, product of MTS Co.) was used to measure the elastic modulus of the interlayer insulating film (temperature: 23°C ±2°C, frequency: 75 Hz, measurement range for elastic modulus: no more than 1/10 of the interlayer insulating film thickness, a range with no variation at the indenting depth).

[Measurement of coating film flattening percentage]

(1) First, an evaluation wafer was prepared. A $SiO_2$ film was formed on the silicon wafer to a thickness of 700 nm. A resist was then formed thereover, and the resist was patterned through the mask with a line/space width of 800/800 nm. The $SiO_2$ film was then etched to a depth of 700 nm. After then peeling off the resist, an $SiO_2$ film was further formed thereover to an additional 100 nm (50 nm on both sides of the lines). This produced a patterned wafer (evaluation wafer) with a height of 700 nm and a line/space width of 900/700 nm. The center space with six lines was used for evaluation of the flattening percentage.

(2) Next, the composition for forming a silica-based coating film was dropped onto the center of the silicon wafer. It was then spin coated for 30 seconds at a rotation rate for a film thickness of 500 ±10 nm after curing of the applied film on the silicon wafer, and heated to 250°C within 30 seconds and baked for 3 minutes. It was then cured at 400°C for 30 minutes in a nitrogen atmosphere to obtain a cured coating film.

(3) The cross-section of the center space with six 900 nm lines (space width: 700 nm) was observed by SEM, and then the film thickness (D2) of the coating film 52 at the center sections of the recesses and the top height (D1) of the lines of the evaluation wafer 51 were measured and the flattening percentage was calculated by the following formula (G) (see Fig. 6).

$$\text{Flattening percentage (\%)} = D2/D1 \times 100 \quad \text{(G)}$$

The properties of the interlayer insulating films obtained in Example 1 and Comparative Example 1 are shown in Table 1.

By comparing the post-application film thicknesses of Example 1 and Comparative Example 1 listed in Table 1, it was confirmed that the tetramethylammonium nitrate used in Example 1 has condensation accelerator catalyst activity. The film thickness shrinkage ratio in Example 1 was 18%, which was significantly lower than the film thickness shrinkage ratio of 32% in Comparative Example 1. The flattening percentage with a substrate having raised and indented sections on the surface reflects the film shrinkage ratio in the curing process, and this was 86% in Example 1, which was more satisfactory than the 79% in Comparative Example 1. The relative permittivity in Example 1 was below 2.5 and the Young's modulus was above 7 GPa, and therefore both a low permittivity property and high mechanical strength were exhibited. In Comparative Example 1, however, the Young's modulus was large but the relative permittivity was larger than 2.5, and therefore a trade-off was experienced between the low permittivity property and high mechanical strength.

[Table 1]

| Measured property | Example 1 | Comp. Ex. 1 |
|---|---|---|
| Total number of specified bonding atoms (M) | 0.48 | 0.48 |
| Solvent type | Aprotic | Aprotic |
| Boiling point of main solvent/(°C) | 150 | 150 |
| Condensation accelerator catalyst/(%) | 0.1 | 0 |
| In-plane uniformity of cured film thickness /(%) | 0.4 | 1.0 |
| Post-application film thickness /(nm) | 594.7 | 727.3 |
| Post-curing film thickness /(nm) | 485.1 | 493.2 |
| Shrinkage ratio/(%) | 18 | 32 |
| Flattening percentage /(%) | 86 | 79 |
| Relative permittivity | 2.4 | 2.7 |
| Young's modulus/GPa | 7.1 | 8.5 |

(Example 2)

To a solution containing 13.3 g of tetraethoxysilane and 10.4 g of methyltriethoxysilane dissolved in 46.4 g of methyl isobutyl ketone, there was added 7.01 g of a 0.644% nitric acid aqueous solution dropwise over 5 minutes while stirring. Upon completion of the dropwise addition, reaction was conducted for 2 hours and then 0.324 g of a 2.38% tetramethylammonium nitrate aqueous solution (pH 3.6) was added, stirring was continued for 2 hours, and a portion of methyl isobutyl ketone and the produced ethanol in the warm bath was distilled off under reduced pressure to obtain 25.7 g of a polysiloxane solution. Next, 2.26 g of polypropylene glycol (PPG725, trade name of Aldrich Co.) as a void-forming compound and 72.1 g of methyl isobutyl ketone were added to 553.9 g of the polysiloxane solution, and the mixture was stirred to dissolution at room temperature for 30 minutes to prepare a composition for forming a silica-based coating film according to the invention. The polypropylene glycol (PPG725, trade name of Aldrich Co.) used as the void-forming compound had a weight reduction of 99.9% at 350°C.

(Example 3)

To a solution containing 13.3 g of tetraethoxysilane and 10.4 g of methyltriethoxysilane dissolved in 47.5 g of ethyleneglycol monomethyl ether acetate, there was added 7.01 g of a 0.644% nitric acid aqueous solution dropwise over 1 minute while stirring. Upon completion of the dropwise addition, reaction was conducted for 1.5 hours and then 0.32 g of a 2.38% tetramethylammonium nitrate aqueous solution (pH 3.6) was added, stirring was continued for 3 hours, and a portion of ethyleneglycol monomethyl ether acetate and the produced ethanol in the warm bath was distilled off under reduced pressure to obtain 50.3 g of a polysiloxane solution. Next, 2.26 g of polypropylene glycol (PPG725, trade name of Aldrich Co.) as a void-forming compound and 47.5 g of ethyleneglycol monomethyl ether acetate were added to the polysiloxane solution, and the mixture was stirred to dissolution at room temperature for 30 minutes to prepare a composition for forming a silica-based coating film according to the invention.

(Example 4)

To a solution containing 13.3 g of tetraethoxysilane and 10.4 g of methyltriethoxysilane dissolved in 46.4 g of propyleneglycol monomethyl ether acetate, there was added 7.01 g of a 0.644% nitric acid aqueous solution dropwise over 1 minute while stirring. Upon completion of the dropwise addition, reaction was conducted for 2 hours and then 0.327 g of a 2.38% tetramethylammonium nitrate aqueous solution (pH 3.6) was added, stirring was continued for 1 hour, and a portion of propyleneglycol monomethyl ether acetate and the produced ethanol in the warm bath was distilled off under reduced pressure to obtain 46.8 g of a polysiloxane solution. Next, 2.26 g of polypropylene glycol (PPG725, trade name of Aldrich Co.) as a void-forming compound and 50.9 g of propyleneglycol monomethyl ether acetate were added to the polysiloxane solution, and the mixture was stirred to dissolution at room temperature for 30 minutes to prepare a composition for forming a silica-based coating film according to the invention.

(Example 5)

To a solution containing 79.8 g of tetraethoxysilane and 62.2 g of methyltriethoxysilane dissolved in 280.3 g of diethyleneglycol dimethyl ether, there was added 42.1 g of a 0.644% nitric acid aqueous solution dropwise over 5 minutes while stirring. Upon completion of the dropwise addition, reaction was conducted for 3 hours, and a portion of diethyleneglycol dimethyl ether and the produced ethanol in the warm bath was distilled off under reduced pressure to obtain 251.0 g of a polysiloxane solution. Next, 9.75 g of a 2.38% tetramethylammonium nitrate aqueous solution (pH 3.6) was added to the polysiloxane solution, 13.6 g of polypropylene glycol (PPG725, trade name of Aldrich Co.) as a void-forming compound and 116.2 g of diethyleneglycol dimethyl ether were further added, and the mixture was stirred to dissolution at room temperature for 30 minutes to prepare a composition for forming a silica-based coating film according to the invention.

(Comparative Example 2)

To a solution containing 13.3 g of tetraethoxysilane and 10.4 g of methyltriethoxysilane dissolved in 46.4 g of ethanol, there was added 7.01 g of a 0.644% nitric acid aqueous solution dropwise over 1 minute while stirring. Upon completion of the dropwise addition, reaction was conducted for 3 hours and then 0.327 g of a 2.38% tetramethylammonium nitrate aqueous solution (pH 3.6) was added to obtain 77.4 g of a polysiloxane solution. Next, 2.26 g of polypropylene glycol (PPG725, trade name of Aldrich Co.) as a void-forming compound and 20.3 g of ethanol were added to the polysiloxane solution, and the mixture was stirred to dissolution at room temperature for 30 minutes to prepare a composition for forming a silica-based coating film.

(Comparative Example 3)

To a solution containing 13.3 g of tetraethoxysilane and 10.4 g of methyltriethoxysilane dissolved in 46.4 g of 1-butanol, there was added 7.00 g of a 0.644% nitric acid aqueous solution dropwise over 3 minutes while stirring. Upon completion of the dropwise addition, reaction was conducted for 1.5 hours and then 0.32 g of a 2.38% tetramethylammonium nitrate aqueous solution (pH 3.6) was added, stirring was continued for 3 hours, and a portion of 1-butanol and the produced ethanol in the warm bath was distilled off under reduced pressure to obtain 50.3 g of a polysiloxane solution. Next, 2.26 g of polypropylene glycol (PPG725, trade name of Aldrich Co.) as a void-forming compound and 47.5 g of 1-butanol were added to the polysiloxane solution, and the mixture was stirred to dissolution at room temperature for 30 minutes to prepare a composition for forming a silica-based coating film.

(Comparative Example 4)

To a solution containing 13.3 g of tetraethoxysilane and 10.4 g of methyltriethoxysilane dissolved in 46.4 g of ethyleneglycol monomethyl ether, there was added 7.01 g of a 0.644% nitric acid aqueous solution dropwise over 1 minute while stirring. Upon completion of the dropwise addition, reaction was conducted for 2 hours and then 0.33 g of a 2.38% tetramethylammonium nitrate aqueous solution (pH 3.6) was added, stirring was continued for 2 hours, and a portion of ethyleneglycol monomethyl ether and the produced ethanol in the warm bath was distilled off under reduced pressure to obtain 41.2 g of a polysiloxane solution. Next, 2.28 g of polypropylene glycol (PPG725, trade name of Aldrich Co.) as a void-forming compound and 56.6 g of ethyleneglycol monomethyl ether were added to the polysiloxane solution, and the mixture was stirred to dissolution at room temperature for 30 minutes to prepare a composition for forming a silica-based coating film.

(Comparative Example 5)

To a solution containing 13.3 g of tetraethoxysilane and 10.4 g of methyltriethoxysilane dissolved in 46.4 g of propyleneglycol monopropyl ether, there was added 7.01 g of a 0.644% nitric acid aqueous solution dropwise over 1 minute while stirring. Upon completion of the dropwise addition, reaction was conducted for 2 hours and then 0.32 g of a 2.38% tetramethylammonium nitrate aqueous solution (pH 3.6) was added, stirring was continued for 1 hour, and a portion of propyleneglycol monopropyl ether and the produced ethanol in the warm bath was distilled off under reduced pressure to obtain 51.0 g of a polysiloxane solution. Next, 2.27 g of polypropylene glycol (PPG725, trade name of Aldrich Co.) as a void-forming compound and 46.8 g of propyleneglycol monopropyl ether were added to the polysiloxane solution, and the mixture was stirred to dissolution at room temperature for 30 minutes to prepare a composition for forming a silica-based coating film.

(Comparative Example 6)

To a solution containing 13.3 g of tetraethoxysilane and 10.4 g of methyltriethoxysilane dissolved in 46.4 g of acetone, there was added 7.01 g of a 0.644% nitric acid aqueous solution dropwise over 1 minute while stirring. Upon completion of the dropwise addition, reaction was conducted for 2 hours and then 0.333 g of a 2.38% tetramethylammonium nitrate aqueous solution (pH 3.6) was added to obtain 77.3 g of a polysiloxane solution. Next, 2.26 g of polypropylene glycol (PPG725, trade name of Aldrich Co.) as a void-forming compound and 20.5 g of acetone were added to the polysiloxane solution, and the mixture was stirred to dissolution at room temperature for 30 minutes to prepare a composition for forming a silica-based coating film.

(Comparative Example 7)

To a solution containing 13.3 g of tetraethoxysilane and 10.4 g of methyltriethoxysilane dissolved in 46.4 g of propyleneglycol diacetate, there was added 7.01 g of a 0.644% nitric acid aqueous solution and 0.326 g of a 2.38% tetramethylammonium nitrate aqueous solution (pH 3.6) dropwise over 1 minute while stirring. Upon completion of the dropwise addition, reaction was conducted for 3.5 hours, and a portion of propyleneglycol diacetate and the produced ethanol in the warm bath was distilled off under reduced pressure to obtain 55.1 g of a polysiloxane solution. Next, 2.26 g of polypropylene glycol (PPG725, trade name of Aldrich Co.) as a void-forming compound and 42.7 g of propyleneglycol diacetate were added to the polysiloxane solution, and the mixture was stirred to dissolution at room temperature for 30 minutes to prepare a composition for forming a silica-based coating film.

(Comparative Example 8)

To a solution containing 13.3 g of tetraethoxysilane and 10.4 g of methyltriethoxysilane dissolved in 46.4 g of γ-butyrolactone, there was added 7.01 g of a 0.644% nitric acid aqueous solution and 0.328 g of a 2.38% tetramethylammonium nitrate aqueous solution (pH 3.6) dropwise within a period of 1 minute while stirring. Upon completion of the dropwise addition, reaction was conducted for 3 hours, and a portion of γ-butyrolactone and the produced ethanol in the warm bath was distilled off under reduced pressure to obtain 54.9 g of a polysiloxane solution. Next, 2.26 g of polypropylene glycol (PPG725, trade name of Aldrich Co.) as a void-forming compound and 42.9 g of γ-butyrolactone were added to the polysiloxane solution, and the mixture was stirred to dissolution at room temperature for 30 minutes to prepare a composition for forming a silica-based coating film.

(Reference Example 1)

To a solution containing 30.4 g of tetramethoxysilane and 108.8 g of methyltrimethoxysilane dissolved in 400.0 g of isopropyl alcohol there was added 50.0 g of an aqueous solution containing 5.88 g of phosphoric acid, dropwise over 5 minutes while stirring. Upon completion of the dropwise addition, reaction was conducted for 3 hours to prepare a composition for forming a silica-based coating film. This composition for Reference Example 1 was a re-test of the siloxane polymer with a reflow property described in Example 1 of Patent document 3, and it was confirmed that the reflow property provided satisfactory flatness using a patterned wafer with recesses. However, significant film shrinkage occurred during curing.

(Example 6)

To a solution containing 17.3 g of tetraethoxysilane and 13.5 g of methyltriethoxysilane dissolved in 60.5 g of cyclohexanone, there was added 9.13 g of a 0.644% nitric acid aqueous solution dropwise over 3 minutes while stirring. Upon completion of the dropwise addition, reaction was conducted for 1.5 hours and then 0.221 g of a 2.38% tetramethylammonium nitrate aqueous solution (pH 3.6) was added, stirring was continued for 2.5 hours, and a portion of cyclohexanone and the produced ethanol in the warm bath was distilled off under reduced pressure to obtain 62.3 g of a polysiloxane solution. Next, 2.96 g of polypropylene glycol (PPG725, trade name of Aldrich Co.) as a void-forming compound and 34.8 g of cyclohexanone were added to the polysiloxane solution, and the mixture was stirred to dissolution at room temperature for 30 minutes to prepare a composition for forming a silica-based coating film according to the invention.

(Example 7)

To a solution containing 17.3 g of tetraethoxysilane and 13.5 g of methyltriethoxysilane dissolved in 60.3 g of cyclohexanone, there was added 9.12 g of a 0.644% nitric acid aqueous solution dropwise over 2 minutes while stirring. Upon completion of the dropwise addition, reaction was conducted for 2 hours and then 1.28 g of a 2.38% tetramethylammonium nitrate aqueous solution (pH 3.6) was added, stirring was continued for 1.5 hours, and a portion of cyclohexanone and the produced ethanol in the warm bath was distilled off under reduced pressure to obtain 62.9 g of a polysiloxane solution. Next, 3.00 g of polypropylene glycol (PPG725, trade name of Aldrich Co.) as a void-forming compound and 34.1 g of cyclohexanone were added to the polysiloxane solution, and the mixture was stirred to dissolution at room temperature for 30 minutes to prepare a composition for forming a silica-based coating film according to the invention.

(Example 8)

To a solution containing 17.3 g of tetraethoxysilane and 13.5 g of methyltriethoxysilane dissolved in 60.3 g of cyclohexanone, there was added 9.13 g of a 0.644% nitric acid aqueous solution dropwise over 2 minutes while stirring. Upon completion of the dropwise addition, reaction was conducted for 1.5 hours and then 4.24 g of a 2.38% tetramethylammonium nitrate aqueous solution (pH 3.6) was added, stirring was continued for 2.5 hours, and a portion of cyclohexanone and the produced ethanol in the warm bath was distilled off under reduced pressure to obtain 60.2 g of a polysiloxane solution. Next, 2.93 g of polypropylene glycol (PPG725, trade name of Aldrich Co.) as a void-forming compound and 36.9 g of cyclohexanone were added to the polysiloxane solution, and the mixture was stirred to dissolution at room temperature for 30 minutes to prepare a composition for forming a silica-based coating film according to the invention.

(Example 9)

To a solution containing 17.3 g of tetraethoxysilane and 13.5 g of methyltriethoxysilane dissolved in 52.4 g of cyclohexanone, there was added 9.13 g of a 0.644% nitric acid aqueous solution dropwise over 3 minutes while stirring. Upon completion of the dropwise addition, reaction was conducted for 2 hours and then 8.45 g of a 2.38% tetramethylammonium nitrate aqueous solution (pH 3.6) was added, stirring was continued for 2 hours, and a portion of cyclohexanone and the produced ethanol in the warm bath was distilled off under reduced pressure to obtain 58.2 g of a polysiloxane solution. Next, 2.94 g of polypropylene glycol (PPG725, trade name of Aldrich Co.) as a void-forming compound and 38.9 g of cyclohexanone were added to the polysiloxane solution, and the mixture was stirred to dissolution at room temperature for 30 minutes to prepare a composition for forming a silica-based coating film according to the invention.

<Fabrication of radiation-curing composition for forming a silica-based coating film>

(Example 10)

To a solution containing 320.4 g of tetraethoxysilane, 551.5 g of methyltriethoxysilane, 6.00 g of a photoacid generator (PAI-101, trade name of Midori Kagaku Co., Ltd.) and 1.276 g of a 2.38% tetramethylammonium nitrate aqueous solution (pH 3.6) dissolved in 1916.9 g of propyleneglycol monomethyl ether acetate, there was added an aqueous solution of 208.3 g deionized water dissolved in 1.62 g of 60 wt% nitric acid, dropwise over 15 minutes while stirring. Upon completion of the dropwise addition, reaction was conducted for 3 hours and then a portion of propyleneglycol monomethyl ether acetate and the produced ethanol in the warm bath was distilled off under reduced pressure to obtain 1082.3 g of a polysiloxane solution. After then adding 417.7 g of propyleneglycol monomethyl ether acetate to the polysiloxane solution, the mixture was stirred to dissolution at room temperature (25°C) for 30 minutes to prepare a radiation-curing composition for forming a silica-based coating film according to the invention.

The radiation-curing composition was then used for patterning (pattern formation). First, 2 mL of the radiation-curing composition was dropped onto the center of a 6-inch silicon wafer, and a spin coating method (700 rpm, 30 seconds) was used to form a coated film on the wafer which was then dried for 30 seconds on a hot plate at 100°C. The dried coated film was then irradiated with i-rays using an exposure device (FPA-3000 iW, trade name of Canon Inc.) at 100 mJ/$cm^2$ through a negative mask having a line pattern with a minimum line width of 2 μm. The wafer with the exposed coating film was heated for 30 seconds with a hot plate at 100°C and then cooled for 30 seconds with a cooling plate (23°C).

Next, a 2.38 wt% tetramethylammonium hydroxide (TMAH) aqueous solution was used as the developing solution with a coater/developer (Mark 7, trade name of Tokyo Electron, Ltd.) for paddle development of the wafer for 30 seconds to dissolve the unexposed sections. The wafer was then rinsed with water and spin dried. A furnace body was used for heating of the spin dried wafer for 30 minutes in a nitrogen atmosphere at 350°C, to obtain a cured coating film on the wafer.

Observation of the pattern shape of the cured composition from the top using an optical microscope and observation of the cross-sectional shape by SEM revealed that highly precise lines had been formed. This confirmed that using the radiation-curing composition of Example 1 provides a pattern precision of 2 μm or smaller.

The properties of the interlayer insulating films obtained in Examples 2-10, Reference Example 1 and Comparative Examples 2-8 are shown in Tables 2 to 6.

[Table 2]

| Measured property | Example 2 | Example 3 | Example 4 | Example 1 | Example 5 |
|---|---|---|---|---|---|
| Total number of specified bonding atoms (M) | 0.48 | 0.48 | 0.48 | 0.48 | 0.48 |
| Solvent type | Aprotic | Aprotic | Aprotic | Aprotic | Aprotic |
| Boiling point of main solvent /(°C) | 116 | 143 | 145 | 150 | 160 |
| Condensation accelerator catalyst /(%) | 0.1 | 0.1 | 0.1 | 0.1 | 0.1 |
| In-plane uniformity of cured film thickness /(%) | 0.6 | 0.5 | 0.4 | 0.4 | 0.6 |
| Shrinkage ratio /(%) | 11 | 17 | 11 | 18 | 18 |
| Flattening percentage /(%) | - | - | 88 | 86 | - |
| Relative permittivity | 2.4 | 2.4 | 2.4 | 2.4 | 2.4 |
| Young's modulus/GPa | 7.1 | 7.0 | 6.9 | 7.1 | 6.7 |

[Table 3]

| Measured property | Comp.Ex. 2 | Comp.Ex. 3 | Comp.Ex. 4 | Comp.Ex. 5 | Comp.Ex. 6 | Comp.Ex. 7 | Comp.Ex. 8 |
|---|---|---|---|---|---|---|---|
| Total number of specified bonding atoms (M) | 0.48 | 0.48 | 0.48 | 0.48 | 0.48 | 0.48 | 0.48 |

(continued)

| Measured property | Comp.Ex. 2 | Comp.Ex. 3 | Comp.Ex. 4 | Comp.Ex. 5 | Comp.Ex. 6 | Comp.Ex. 7 | Comp.Ex. 8 |
|---|---|---|---|---|---|---|---|
| Solvent type | Protic | Protic | Protic | Protic | Aprotic | Aprotic | Aprotic |
| Boiling point of main solvent/ (°C) | 78 | 117 | 127 | 150 | 56 | 190 | 204 |
| Condensation accelerator catalyst/(%) | 0.1 | 0.1 | 0.1 | 0.1 | 0.1 | 0.1 | 0.1 |
| In-plane uniformity of cured film thickness /(%) | 10.3 | 1.2 | 2.4 | 1.1 | 6.2 | 10.2 | 12.2 |
| Shrinkage ratio/(%) | 15 | 36 | 28 | 35 | 13 | 90 | 80 |
| Flattening percentage / (%) | - | 75 | - | - | - | - | - |
| Relative permittivity | 2.6 | 2.8 | - | 2.4 | 2.4 | 2.4 | - |
| Young's modulus/GPa | 6.0 | 5.8 | - | 5.0 | 7.5 | 7.3 | - |

[Table 4]

| Measured property | Reference Example 1 |
|---|---|
| Total number of specified bonding atoms (M) | 1.0 |
| Solvent type | Protic |
| Boiling point of main solvent /(°C) | 82 |
| Condensation accelerator catalyst /(%) | 0 |
| In-plane uniformity of cured film thickness /(%) | 4.2 |
| Shrinkage ratio /(%) | 40 |
| Flattening percentage /(%) | 85 |
| Relative permittivity | 3.1 |
| Young's modulus /GPa | 4.4 |

[Table 5]

| Measured property | Example 6 | Example 1 | Example 7 | Example 8 | Example 9 |
|---|---|---|---|---|---|
| Total number of specified bonding atoms (M) | 0.48 | 0.48 | 0.48 | 0.48 | 0.48 |
| Solvent type | Aprotic | Aprotic | Aprotic | Aprotic | Aprotic |
| Boiling point of main solvent /(°C) | 150 | 150 | 150 | 150 | 150 |
| Condensation accelerator catalyst/(%) | 0.05 | 0.1 | 0.3 | 1.0 | 2.0 |

(continued)

| Measured property | Example 6 | Example 1 | Example 7 | Example 8 | Example 9 |
|---|---|---|---|---|---|
| In-plane uniformity of cured film thickness /(%) | 0.9 | 0.6 | 1.7 | 0.6 | 0.9 |
| Shrinkage ratio/(%) | 19 | 18 | 18 | 18 | 19 |
| Flattening percentage/(%) | - | 86 | - | - | 88 |
| Relative permittivity | 2.5 | 2.4 | 2.4 | 2.4 | 2.4 |
| Young's modulus /GPa | 6.5 | 7.1 | 6.3 | 6.2 | 6.2 |

[Table 6]

| Measured property | Example 10 |
|---|---|
| Total number of specified bonding atoms (M) | 0.67 |
| Solvent type | Aprotic |
| Boiling point of main solvent /(°C) | 145 |
| Condensation accelerator catalyst /(%) | 0.01 |
| In-plane uniformity of cured film thickness /(%) | 2.9 |
| Shrinkage ratio /(%) | 22 |
| Flattening percentage /(%) | - |
| Relative permittivity | 3.6 |
| Young's modulus /GPa | 8.8 |

The film thickness shrinkage ratios of the coating films of Examples 2-6 were 11-18%, and significantly lower than the film thickness shrinkage ratio of 32% for the coating film of Comparative Example 1. The flattening percentage on the surface of the substrate having raised and indented sections on the surface reflected the shrinkage ratio of the film thickness throughout the curing process. The flattening percentage was 88% in Example 4, which was more satisfactory than the 79% in Comparative Example 1. The in-plane uniformity of film thickness of the coating films of Examples 2-6 was satisfactory at 1% or less. The relative permittivity of the coating films of Examples 2-6 was 2.5 or below and the Young's modulus was 6.7 GPa or above, indicating that both a low permittivity property and high mechanical strength were exhibited.

The film thickness shrinkage ratio of the coating film of Comparative Example 2 was low at 15%, but the in-plane uniformity of the coating film exceeded 10%, rendering it unsuitable for uses that require flatness. The low film thickness shrinkage ratio and the high in-plane uniformity of the cured film is attributed to the fact that the boiling point of the main solvent was 80°C or below. Also, since the relative permittivity was greater than 2.5 and the Young's modulus was no higher than 6 GPa, the film did not satisfy the conditions of a low permittivity property and high mechanical strength.

The in-plane uniformity of the coating films of Comparative Examples 3-5 were 3% or less, but the film thickness shrinkage ratios were 28% or higher, and therefore the films did not satisfy the conditions of a low permittivity property and high mechanical strength. The flattening percentage on the surface of the substrate having raised and indented sections on the surface reflects the shrinkage ratio of the film thickness throughout the curing process, and this was 75% in Comparative Example 3.

The film thickness shrinkage ratio of the coating film of Comparative Example 6 was low at 13%, but the in-plane uniformity of the film thickness exceeded 6%, rendering it unsuitable for uses that require flatness. The low film thickness shrinkage ratio and the high in-plane uniformity of the film thickness is attributed to the fact that the boiling point of the main solvent was 80°C or below. The relative permittivity was 2.5 or less and the Young's modulus was 7 GPa or above, and therefore the film satisfied the conditions of a low permittivity property and high mechanical strength. This is attributed to the fact that the main solvent was an aprotic solvent.

The film thickness shrinkage ratios of the coating films of Comparative Examples 7-8 were 80% or higher, but the in-plane uniformity of film thickness exceeded 10%, rendering the films unsuitable for uses that require flatness. The high film thickness shrinkage ratio and the high in-plane uniformity of film thickness is attributed to the fact that the boiling point of the main solvent was 180°C or higher. The relative permittivity was 2.5 or less and the Young's modulus was 7

GPa or above, and therefore the films satisfied the conditions of a low permittivity property and high mechanical strength. This is attributed to the fact that the main solvent was an aprotic solvent.

The film thickness shrinkage ratio of the coating film of Reference Example 1 was large at 40%, but because of its reflow property, its flattening percentage was satisfactory at 85%. However, the relative permittivity was 3.3 while the Young's modulus was 4.4 GPa, and therefore the film did not satisfy the conditions of a low permittivity property and high mechanical strength.

The film thickness shrinkage ratios of the coating films of Examples 6-9 were 18-19%, and therefore significantly lower than the film thickness shrinkage ratio of 32% for the coating film of Comparative Example 1. The flattening percentage on the surface of the substrate having raised and indented sections on the surface reflects the shrinkage ratio of the film thickness throughout the curing process, and this was 88% in Example 9, which was more satisfactory than the 79% in Comparative Example 1.

The film thickness shrinkage ratio of the coating film of Example 10 was 22%, which was significantly smaller than the shrinkage ratio of 32% in Comparative Example 1. Also, the in-plane uniformity of film thickness was satisfactory at 3% or less.

[Example 11 (0.05 part by weight TMA)]

To a solution containing 77.3 g of tetraethoxysilane and 60.3 g of methyltriethoxysilane dissolved in 270.8 g of cyclohexanone there was added dropwise a solution of 0.44 g of 60% nitric acid in 40.5 g of water, over a period of 10 minutes while stirring. Upon completion of the dropwise addition, reaction was conducted for 1.5 hours and then 0.95 g of a 2.4 wt% tetramethylammonium nitrate aqueous solution was added and reaction was continued for 0.5 hour to obtain a polysiloxane solution. Next, a rotary evaporator was used to distill off the produced ethanol and low-boiling-point substances in the warm bath under reduced pressure, and then 11.8 g of polypropylene glycol was added to prepare 400 g of a composition for forming a silica-based coating film.

[Example 12 (0.1 part by weight TMA)]

To a solution containing 77.3 g of tetraethoxysilane and 60.3 g of methyltriethoxysilane dissolved in 269.8 g of cyclohexanone there was added dropwise a solution of 0.44 g of 60% nitric acid in 40.5 g of water, over a period of 10 minutes while stirring. Upon completion of the dropwise addition, reaction was conducted for 1.5 hours and then 1.9 g of a 2.4 wt% tetramethylammonium nitrate aqueous solution was added and reaction was continued for 0.5 hour to obtain a polysiloxane solution. Next, a rotary evaporator was used to distill off the produced ethanol and low-boiling-point substances in the warm bath under reduced pressure, and then 11.8 g of polypropylene glycol was added to prepare 400 g of a composition for forming a silica-based coating film.

[Example 13 (0.3 part by weight TMA)]

To a solution containing 77.3 g of tetraethoxysilane and 60.3 g of methyltriethoxysilane dissolved in 266.0 g of cyclohexanone there was added dropwise a solution of 0.44 g of 60% nitric acid in 40.5 g of water, over a period of 10 minutes while stirring. Upon completion of the dropwise addition, reaction was conducted for 1.5 hours and then 5.7 g of a 2.4 wt% tetramethylammonium nitrate aqueous solution was added and reaction was continued for 0.5 hour to obtain a polysiloxane solution. Next, a rotary evaporator was used to distill off the produced ethanol and low-boiling-point substances in the warm bath under reduced pressure, and then 11.8 g of polypropylene glycol was added to prepare 400 g of a composition for forming a silica-based coating film.

[Comparative Example 9 (1.0 part by weight TMA)]

To a solution containing 77.3 g of tetraethoxysilane and 60.3 g of methyltriethoxysilane dissolved in 252.7 g of cyclohexanone there was added dropwise a solution of 0.44 g of 60% nitric acid in 40.5 g of water, over a period of 10 minutes while stirring. Upon completion of the dropwise addition, reaction was conducted for 1.5 hours and then 19 g of a 2.4 wt% tetramethylammonium nitrate aqueous solution was added and reaction was continued for 0.5 hour to obtain a polysiloxane solution. Next, a rotary evaporator was used to distill off the produced ethanol and low-boiling-point substances in the warm bath under reduced pressure, and then 11.8 g of polypropylene glycol was added to prepare 400 g of a composition for forming a silica-based coating film.

[Comparative Example 10 (2.0 parts by weight TMA)]

To a solution containing 77.3 g of tetraethoxysilane and 60.3 g of methyltriethoxysilane dissolved in 233.8 g of

cyclohexanone there was added dropwise a solution of 0.44 g of 60% nitric acid in 40.5 g of water, over a period of 10 minutes while stirring. Upon completion of the dropwise addition, reaction was conducted for 1.5 hours and then 37.8 g of a 2.4 wt% tetramethylammonium nitrate aqueous solution was added and reaction was continued for 0.5 hour to obtain a polysiloxane solution. Next, a rotary evaporator was used to distill off the produced ethanol and low-boiling-point substances in the warm bath under reduced pressure, and then 11.8 g of polypropylene glycol was added to prepare 400 g of a composition for forming a silica-based coating film.

[Fabrication of coating films for flatness evaluation]

The composition for forming a silica-based coating films prepared in Examples 11-13 and in Comparative Examples 9 and 10 were each spin coated for 30 seconds at a rotation rate of 2000-3000 rpm onto a patterned wafer having recesses with widths of 750 nm and depths of 700 nm, to a film thickness of 45% with respect to the depths of the recesses after the final heating step (final curing) (that is, coating with conditions such that after application of the composition for forming a silica-based coating film onto a flat Si wafer and subjecting it to final heating, the film thickness of the silica-based coating film was 45% of 700 nm). The spin coating was followed by heating at 250°C for 3 minutes. The coating film was then subjected to final curing for 30 minutes at 425°C in a quartz tube furnace controlled to an $O_2$ concentration of about 100 ppm.

[Fabrication of coating films for measurement of electrical characteristics (relative permittivity) and film strength (elastic modulus)]

The composition for forming a silica-based coating films prepared in Examples 11-13 and in Comparative Examples 9 and 10 were each dropped onto a Si wafer and spin coated for 30 seconds at a rotation rate of 1000-3000 rpm to a silica-based coating film thickness of 0.5-0.6 μm. The spin coating was followed by heating at 250°C for 3 minutes. The coating film was then subjected to final curing for 30 minutes at 425°C in a quartz tube furnace controlled to an $O_2$ concentration of about 100 ppm. A small silica-based coating film thickness is not preferred because the underlying layer will become more prominent.

The silica-based coating films formed by the film-forming method described above were evaluated for flatness, electrical characteristics and film strength by the methods described above.

[Evaluation results]

The evaluation results are shown in Table 7.

[Table 7]

| | Example 11 | Example 12 | Example 13 | Comp. Ex. 9 | Comp. Ex. 10 |
|---|---|---|---|---|---|
| Tetramethylammonium nitrate content (parts by wt.) | 0.05 | 0.1 | 0.3 | 1.0 | 2.0 |
| Flattening percentage (%) | 85 | 83 | 80 | 73 | 73 |
| Relative permittivity (-) | 2.4 | 2.4 | 2.4 | 2.4 | 2.3 |
| Elastic modulus (GPa) | 5.7 | 5.9 | 6.0 | 6.2 | 8.0 |

The flatness was excellent in Examples 1-3 which used composition for forming a silica-based coating films of the invention comprising (a) a siloxane resin, (b) a solvent capable of dissolving component (a) and (c) an onium salt, wherein the proportion of component (c) was 0.001-0.5 wt% with respect to the total of component (a). The low dielectricity and mechanical strength were also adequate.

The coating film, silica-based coating film and a method for forming it, composition for forming a silica-based coating film, and electronic parts comprising the silica-based coating film, according to the invention, allow excellent surface flatness to be realized.

## Claims

**1.** A coating film obtained by curing an applied film formed by application of a composition containing an organic solvent

with a boiling point of 80°C or higher, wherein the shrinkage ratio of the film thickness from the applied film immediately after application is no greater than 27%.

2. A coating film according to claim 1, wherein the composition contains a resin produced by condensation reaction caused by heat or radiation.

3. A coating film according to claim 1 or 2, which is formed from a composition for forming a silica-based coating film.

4. A coating film obtained by curing an applied film formed on the surface of a substrate having raised and indented sections on the surface, wherein the coating film has a film thickness shrinkage ratio of no greater than 27% from the applied film immediately after formation.

5. A composition for forming a silica-based coating film which forms a coating film according to claim 3, the composition for forming a silica-based coating film comprising
component (a): a siloxane resin,
component (b): an organic solvent containing at least one aprotic solvent, and
component (c): a condensation accelerator catalyst.

6. A composition for forming a silica-based coating film according to claim 5, wherein the proportion of component (c) is 0.001-0.5 part by weight with respect to 100 parts by weight as the total of component (a).

7. A composition for forming a silica-based coating film according to claim 5 or 6, wherein the condensation accelerator catalyst is an onium salt.

8. A composition for forming a silica-based coating film according to any one of claims 5 to 7, wherein the aprotic solvent contains at least one aprotic solvent selected from the group consisting of ether-based solvents, ester-based solvents and ketone-based solvents.

9. A composition for forming a silica-based coating film according to any one of claims 5 to 8, wherein the boiling point of the aprotic solvent is 80-180°C.

10. A composition for forming a silica-based coating film comprising (a) a siloxane resin, (b) a solvent capable of dissolving component (a) and (c) an onium salt, wherein the proportion of component (c) is 0.001-0.5 part by weight with respect to 100 parts by weight as the total of component (a).

11. A composition for forming a silica-based coating film according to any one of claims 5 to 10, wherein component (c) is an ammonium salt.

12. A composition for forming a silica-based coating film according to any one of claims 5 to 11, wherein the proportion of component (c) is 0.001-0.4 part by weight with respect to 100 parts by weight as the total of component (a).

13. A composition for forming a silica-based coating film according to any one of claims 5 to 11, wherein the proportion of component (c) is 0.001-0.3 part by weight with respect to 100 parts by weight as the total of component (a).

14. A composition for forming a silica-based coating film according to any one of claims 5 to 11, wherein the proportion of component (c) is 0.001-0.2 part by weight with respect to 100 parts by weight as the total of component (a).

15. A composition for forming a silica-based coating film according to any one of claims 5 to 11, wherein the proportion of component (c) is 0.001-0.1 part by weight with respect to 100 parts by weight as the total of component (a).

16. A composition for forming a silica-based coating film according to any one of claims 5 to 11, wherein the proportion of component (c) is 0.01-0.1 part by weight with respect to 100 parts by weight as the total of component (a).

17. A composition for forming a silica-based coating film according to any one of claims 5 to 16, wherein component (a) contains a siloxane resin obtained by hydrolytic condensation of a compound represented by the following general formula (1):

$$R^1_nSiX_{4-n} \qquad (1)$$

[wherein $R^1$ represents an H atom or F atom, a group containing a B atom, N atom, Al atom, P atom, Si atom, Ge atom or Ti atom, or a C1-20 organic group, X represents a hydrolyzable group and n represents an integer of 0-2, with the proviso that when n is 2, each $R^1$ may be the same or different, and when n is 0-2, each X may be the same or different].

**18.** A composition for forming a silica-based coating film according to claim 17, wherein component (a) is one wherein the total number of one or more atoms selected from the group consisting of H atoms, F atoms, B atoms, N atoms, Al atoms, P atoms, Si atoms, Ge atoms, Ti atoms and C atoms that are bonded to each Si atom forming a siloxane bond in the siloxane resin is less than 1.0.

**19.** A composition for forming a silica-based coating film according to claim 17, wherein component (a) contains a resin wherein the total number of one or more atoms selected from the group consisting of H atoms, F atoms, B atoms, N atoms, Al atoms, P atoms, Si atoms, Ge atoms, Ti atoms and C atoms that are bonded to each Si atom forming a siloxane bond in the siloxane resin is no greater than 0.65.

**20.** A composition for forming a silica-based coating film according to any one of claims 5 to 19, which further contains a void-forming compound that undergoes thermal decomposition or volatilization at a heating temperature of 200-500°C.

**21.** A composition for forming a silica-based coating film according to any one of claims 5 to 20, which is applied onto a substrate having raised and indented sections on the surface.

**22.** A composition for forming a silica-based coating film for formation of a silica-based coating film by application onto the surface of a substrate having raised and indented sections on the surface, wherein the film thickness shrinkage ratio from the applied film immediately after application to the silica-based coating film obtained by curing of the applied film is no greater than 27%, and the composition for forming a silica-based coating film contains an organic solvent with a boiling point of 80°C or higher.

**23.** A method for forming a silica-based coating film which forms a silica-based coating film on a substrate, wherein a composition for forming a silica-based coating film according to any one of claims 5 to 21 is applied onto a substrate to form an applied film, the organic solvent in the applied film is removed, and the applied film is fired.

**24.** A method for forming a silica-based coating film according to claim 23, wherein the surface of the substrate on which the composition for forming a silica-based coating film is applied has raised and indented sections.

**25.** A method for forming a silica-based coating film that comprises a step of applying the composition for forming a silica-based coating film onto the surface of a substrate having raised and indented sections on the surface to form an applied film, a step of removing the organic solvent in the applied film and a step of firing the applied film after the removing step to obtain a silica-based coating film,
wherein the composition for forming a silica-based coating film is subjected to condensation reaction before the step of obtaining the silica-based coating film, so that the film thickness shrinkage ratio from the applied film immediately after the step of forming the applied film, to the silica-based coating film immediately after the step of firing, is no greater than 27%.

**26.** A silica-based coating film formed on a substrate by a method for forming a silica-based coating film according to claim 23 or 24.

**27.** A silica-based coating film according to claim 26, which is formed between adjacent conductive layers among a plurality of conductive layers formed on a substrate.

**28.** An electronic part comprising a silica-based coating film according to claim 26 or 27 formed on a substrate.

Fig.1

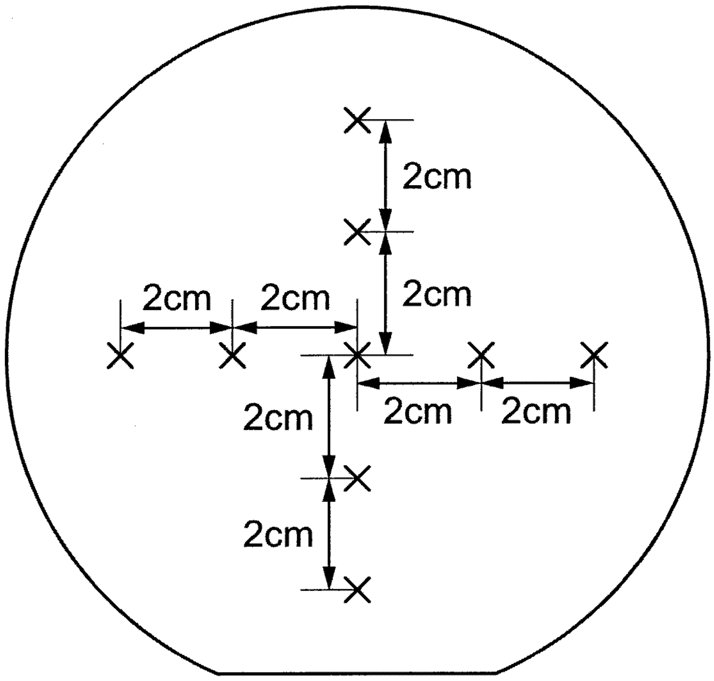

*Fig.2*

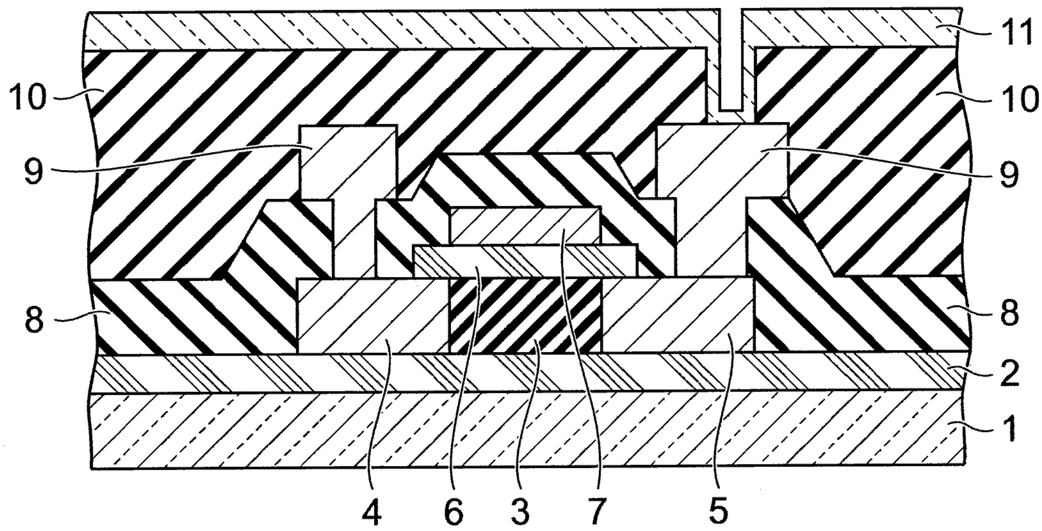

# Fig.3

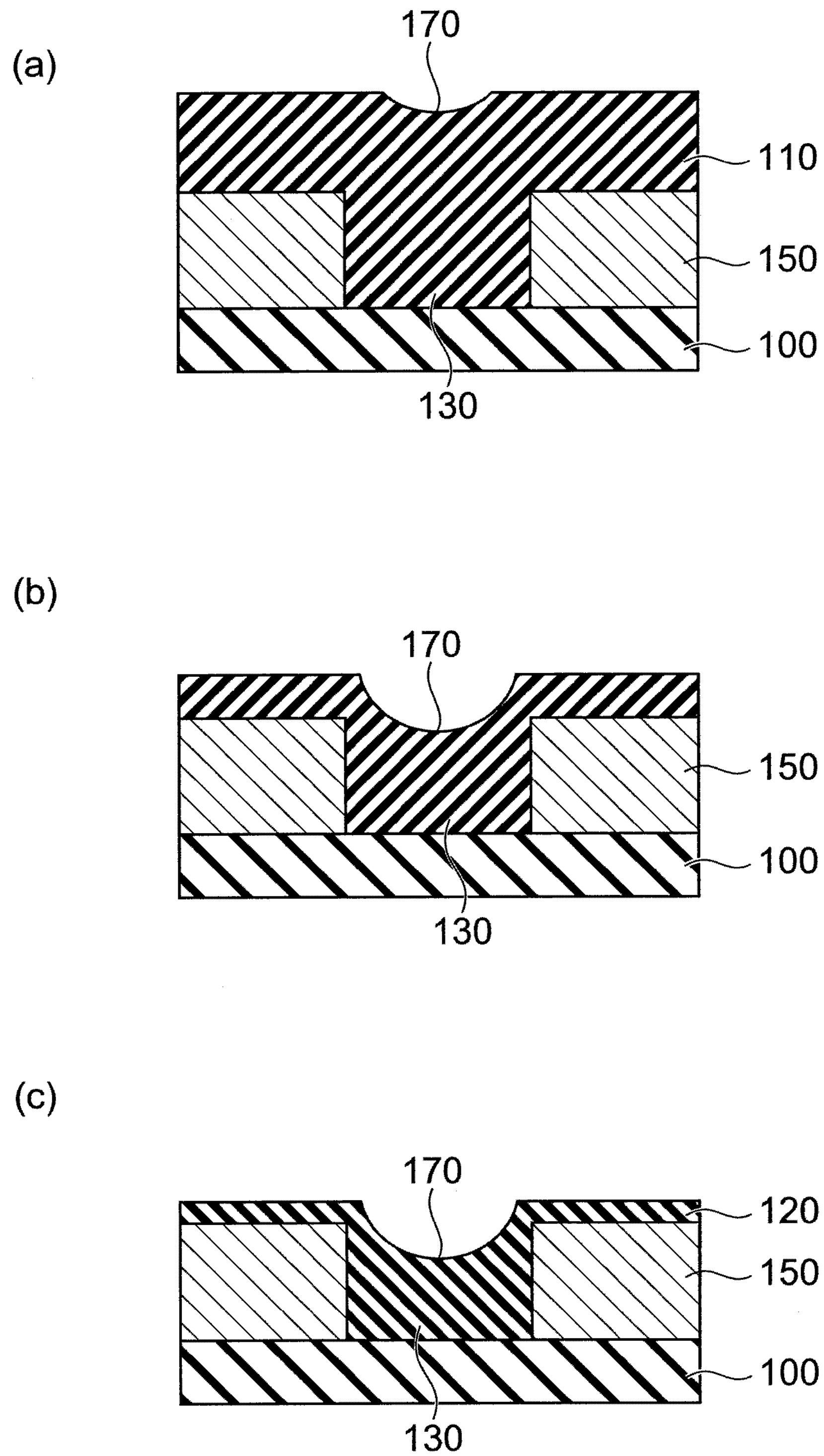

*Fig.4*

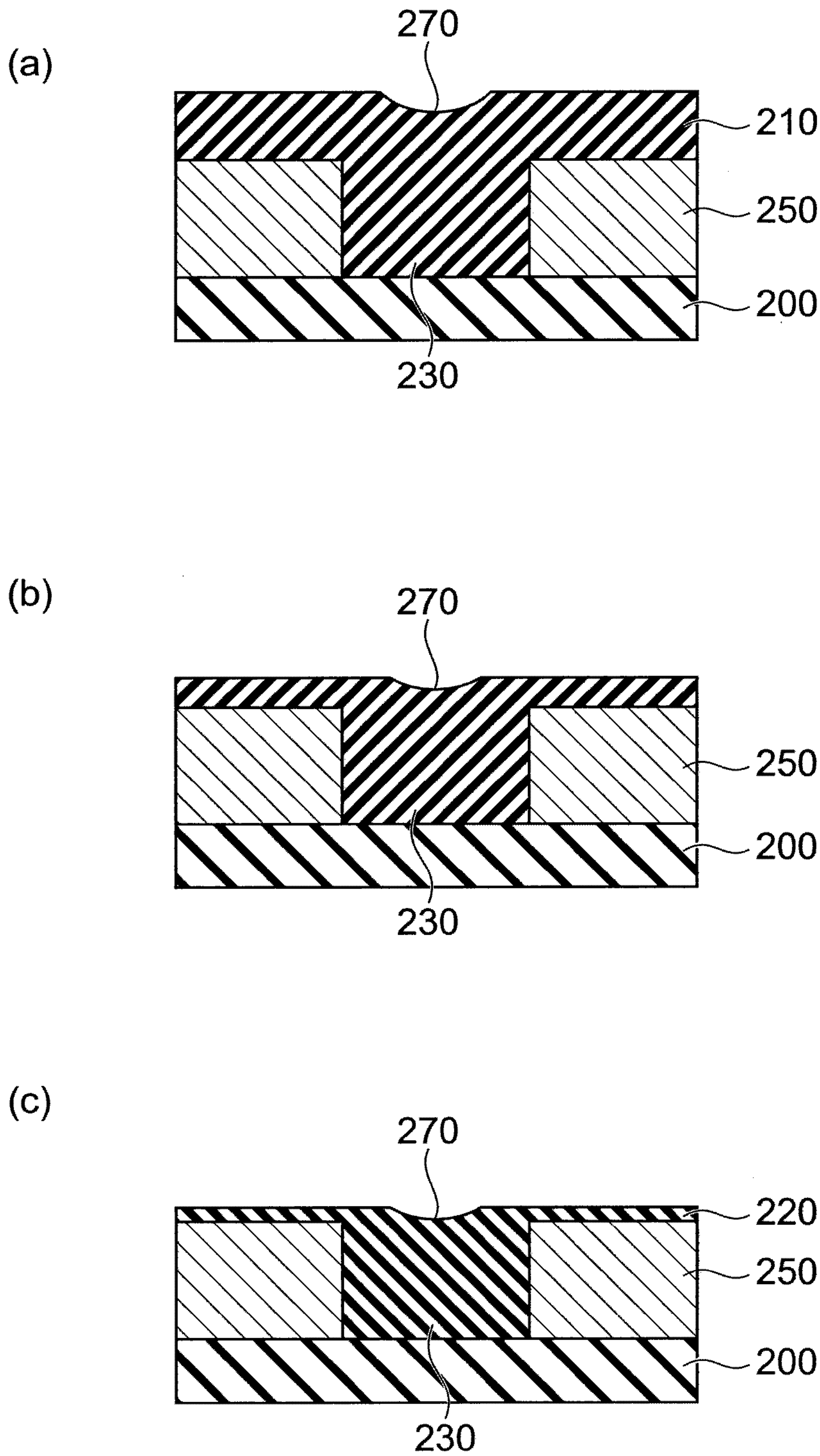

*Fig.5*

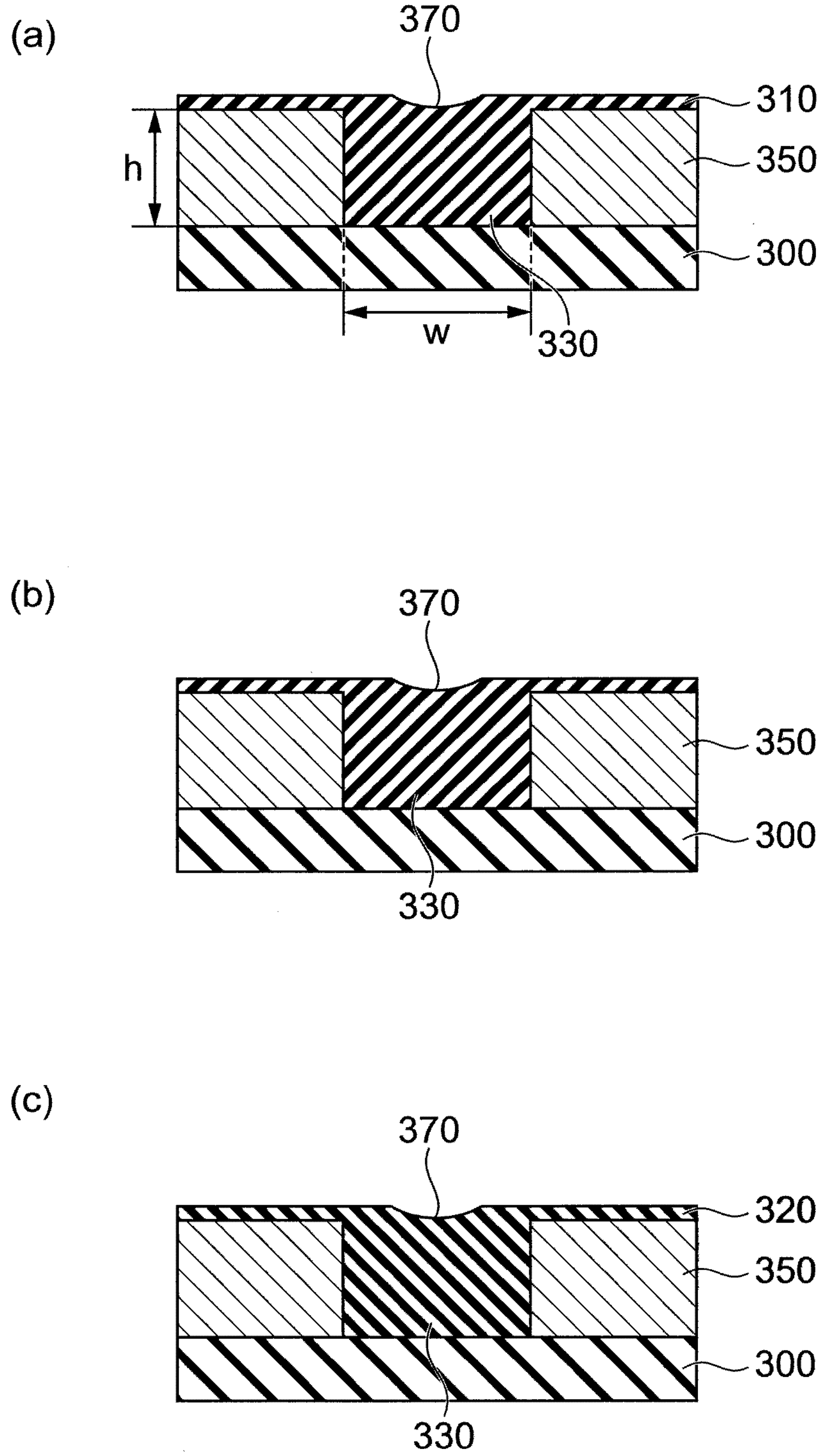

# Fig.6

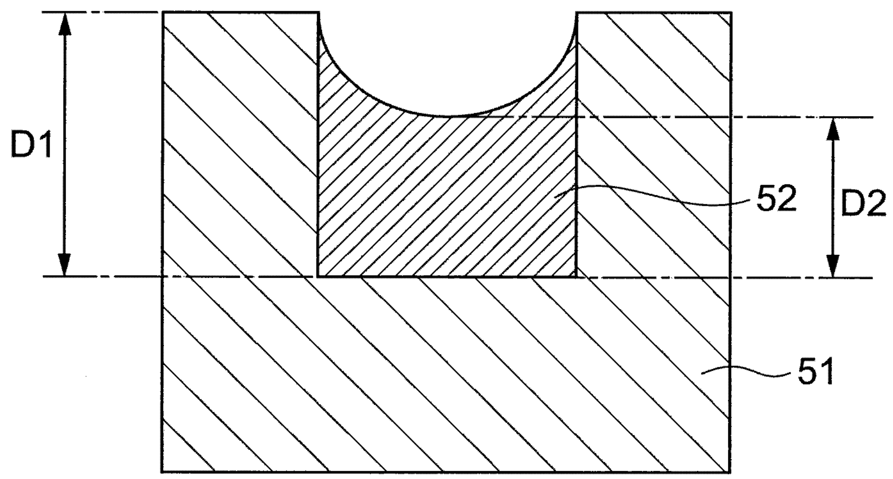


FLATTENING PERCENTAGE(%)=(D2/D1)×100

## INTERNATIONAL SEARCH REPORT

International application No.
PCT/JP2005/023499

A. CLASSIFICATION OF SUBJECT MATTER
*C09D201/00*(2006.01), *C01B33/12*(2006.01), *C09D1/00*(2006.01), *C09D183/02*(2006.01), *C09D183/04*(2006.01), *H01L21/316*(2006.01)

According to International Patent Classification (IPC) or to both national classification and IPC

B. FIELDS SEARCHED

Minimum documentation searched (classification system followed by classification symbols)
C01B33/00-C01B33/46, C09D1/00-C09D201/10, H01L21/316

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 2002-88304 A (Ube-Nitto Kasei Co., Ltd.), 27 March, 2002 (27.03.02), Full text (Family: none) | 1-3 |
| X | JP 2004-277501 A (Hitachi Chemical Co., Ltd.), 07 October, 2004 (07.10.04), Full text (Family: none) | 1-3 |
| X | JP 2003-64306 A (Hitachi Chemical Co., Ltd.), 05 March, 2003 (05.03.03), Full text (Family: none) | 1-3 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 20 March, 2006 (20.03.06) | 04 April, 2006 (04.04.06) |
| Name and mailing address of the ISA/ Japanese Patent Office | Authorized officer |
| Facsimile No. | Telephone No. |

Form PCT/ISA/210 (second sheet) (April 2005)

**INTERNATIONAL SEARCH REPORT**

International application No.
PCT/JP2005/023499

C (Continuation). DOCUMENTS CONSIDERED TO BE RELEVANT

| Category* | Citation of document, with indication, where appropriate, of the relevant passages | Relevant to claim No. |
|---|---|---|
| X | JP 2001-98218 A (Hitachi Chemical Co., Ltd.), 10 April, 2001 (10.04.01), Full text (Family: none) | 1-3 |

Form PCT/ISA/210 (continuation of second sheet) (April 2005)

**INTERNATIONAL SEARCH REPORT**

International application No.
PCT/JP2005/023499

**Box No. II Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

**Box No. III Observations where unity of invention is lacking (Continuation of item 3 of first sheet)**

This International Searching Authority found multiple inventions in this international application, as follows:
See extra sheet.

1. ☐ As all required additional search fees were timely paid by the applicant, this international search report covers all searchable claims.
2. ☐ As all searchable claims could be searched without effort justifying an additional fee, this Authority did not invite payment of any additional fee.
3. ☐ As only some of the required additional search fees were timely paid by the applicant, this international search report covers only those claims for which fees were paid, specifically claims Nos.:

4. ☒ No required additional search fees were timely paid by the applicant. Consequently, this international search report is restricted to the invention first mentioned in the claims; it is covered by claims Nos.:
1-3

**Remark on Protest** the

☐ The additional search fees were accompanied by the applicant's protest and, where applicable, payment of a protest fee..

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (April 2005)

INTERNATIONAL SEARCH REPORT

International application No.
PCT/JP2005/023499

Continuation of Box No.III of continuation of first sheet(2)

(A) Claims 1-28

(B) Reasons

At least the following technical matters (1)-(4) are not considered to fall under the category of "special technical features" in the meaning of the second sentence of Rule 13.2 of the Regulations under the PCT because the matters are already known in the art as apparent from the fact that they are described in, e.g., the documents (D1)-(D4) shown below.

Therefore, there is no technical relationship, among the 20 invention groups included in the claims of this international application, which involves one or more, identical or corresponding "special technical features." They are hence not so linked as to form a single general inventive concept.

<Known technical matters>

(1)
A film which is obtained by applying a composition containing an organic solvent having a boiling point of 80°C or higher and curing the resultant coating film and which has undergone a shrinkage in thickness of 27% or less based on the coating film immediately after application.

(2)
A silica film-forming composition which forms a film and comprises: ingredient (a), i.e., a siloxane resin; ingredient (b), i.e., an organic solvent comprising at least one aprotic solvent; and ingredient (c), i.e., a condensation acceleration catalyst.

(3)
A silica film-forming composition which comprises a siloxane resin (a), a solvent (b) in which the ingredient (a) is soluble, and an onium salt (c), wherein the amount of the ingredient (c) is 0.001-0.5 parts by weight per 100 parts by weight of the whole ingredient (a).

(4)
A method of silica film formation which comprises applying a silica film-forming composition on a substrate to form a coating film, removing the organic solvent from the coating film, and then burning the coating film.

<Documents>
D1: JP 2002-88304 A (Ube-Nitto Kasei Co., Ltd.) March 27, 2002
D2: JP 2004-277501 A (Hitachi Chemical Co., Ltd.) October 7, 2004
D3: JP 2003-64306 A (Hitachi Chemical Co., Ltd.) March 5, 2003
D4: JP 2001-98218 A (Hitachi Chemical Co., Ltd.) April 10, 2001

(continued on next page)

INTERNATIONAL SEARCH REPORT

International application No.
PCT/JP2005/023499

<Twenty invention groups involved in the claims of this international application>

• Invention group 1 (main invention)
· A given film whose technical feature resides in that it has been obtained by applying a composition containing a resin produced through a given condensation reaction and curing the resultant coating film (claims 1-3)
• Invention group 2 (2nd invention)
· A given film whose technical feature resides in that it has been obtained by applying a silica film-forming composition and curing the resultant coating film (claim 3)
• Invention group 3 (3rd invention)
· A film obtained by curing a coating film formed on a substrate of a given shape, the film having a degree of given thickness shrinkage within a given range (claim 4)
• Invention group 4 (4th invention)
· The silica film-forming composition of claim 5 whose technical feature resides in the ingredient (c) (claims 5-7 and 11-16)
• Invention group 5 (5th invention)
· The silica film-forming composition of claim 5 whose technical feature resides in the ingredient (b) (claims 5 and 8-9)
• Invention group 6 (6th invention)
· The silica film-forming composition of claim 5 whose technical feature resides in the ingredient (a) (claims 5 and 17-19)
• Invention group 7 (7th invention)
· The silica film-forming composition of claim 5 whose technical feature resides in that it contains a given void-forming compound (claims 5 and 20)
• Invention group 8 (8th invention)
· The silica film-forming composition of claim 5 whose technical feature resides in that it is to be applied on a given substrate (claims 5 and 21)
• Invention group 9 (9th invention)
· A method of forming a silica film on a substrate by a given means from the silica film-forming composition of claim 5 (claims 5 and 23-24)
• Invention group 10 (10th invention)
· A silica film formed on a substrate by a given means from the silica film-forming composition of claim 5 (claims 5 and 26-27)
• Invention group 11 (11th invention)
· An electronic part having a silica film formed on a substrate by a given means from the silica film-forming composition of claim 5 (claims 5 and 28)
• Invention group 12 (12th invention)
· The silica film-forming composition of claim 10 whose technical feature resides in the ingredient (c) (claims 10-16)
• Invention group 13 (13th invention)
· The silica film-forming composition of claim 10 whose technical feature resides in the ingredient (a) (claims 10 and 17-19)
• Invention group 14 (14th invention)
· The silica film-forming composition of claim 10 whose technical feature resides in that it contains a given void-forming compound (claims 5 and 20)

(continued on next page)

**INTERNATIONAL SEARCH REPORT**

International application No.
PCT/JP2005/023499

• Invention group 15 (15th invention)

· The silica film-forming composition of claim 10 whose technical feature resides in that it is to be applied on a given substrate (claims 10 and 21)

• Invention group 16 (16th invention)

· A method of forming a silica film on a substrate by a given means from the silica film-forming composition of claim 10 (claims 10 and 23-24)

• Invention group 17 (17th invention)

· A silica film formed on a substrate by a given means from the silica film-forming composition of claim 10 (claims 10 and 26-27)

• Invention group 18 (18th invention)

· An electronic part having a silica film formed on a substrate by a given means from the silica film-forming composition of claim 10 (claims 10 and 28)

• Invention group 19 (19th invention)

· A silica film-forming composition which is for forming a silica film through application on the surface of a substrate of a given shape, the composition having a degree of given thickness shrinkage within a given range and containing a given organic solvent (claim 22)

• Invention group 20 (20th invention)

· A method of silica film formation which comprises given steps (claim 25)

Form PCT/ISA/210 (extra sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 11322992 A
- JP 11310411 A
- JP 3370792 B
- JP 1216543 A